# EUROPÄISCHE PATENTSCHRIFT

(11) **EP 3 027 570 B1**
(45) Veröffentlichungstag und Bekanntmachung des Hinweises auf die Patenterteilung: **27.11.2019**
(21) Anmeldenummer: 14745102.5
(22) Anmeldetag: 24.07.2014
(51) Int. Cl.: C03B 19/06, C03B 19/09, G02B 13/14, G02B 13/16, G03F 7/20, G02B 1/02, C03C 3/06

(54) **VERFAHREN ZUM BELADEN EINES ROHLINGS AUS QUARZGLAS MIT WASSERSTOFF, LINSENELEMENT UND PROJEKTIONSOBJEKTIV**
METHOD FOR LOADING A BLANK MADE OF QUARTZ GLASS WITH HYDROGEN, LENS ELEMENT, AND PROJECTION OBJECT LENS
PROCÉDÉ PERMETTANT DE CHARGER EN HYDROGÈNE UNE ÉBAUCHE EN VERRE DE QUARTZ, ÉLÉMENT DE LENTILLE ET OBJECTIF DE PROJECTION

(30) Priorität: 02.08.2013 DE 102013215292
(43) Veröffentlichungstag der Anmeldung: 08.06.2016
(73) Patentinhaber: Carl Zeiss SMT GmbH, 73447 Oberkochen (DE)
(72) Erfinder: EVA, Eric, 73434 Aalen (DE)
(74) Vertreter: Kohler Schmid Möbus Patentanwälte
(86) Internationale Anmeldenummer: PCT/EP2014/065950
(87) Internationale Veröffentlichungsnummer: WO 2015/014717

(56) Entgegenhaltungen:
- EP-A1- 1 233 005
- EP-A1- 1 327 612
- DE-A1-102009 016 599
- DATABASE WPI Week 200957 27. August 2009 (2009-08-27) Thomson Scientific, London, GB; AN 2009-M91581 XP002733836, -& JP 2009 190958 A (SHINETSU SEKIEI KK) 27. August 2009 (2009-08-27)

## Beschreibung

### Hintergrund der Erfindung

Die Erfindung betrifft ein Verfahren zum Beladen eines Rohlings aus Quarzglas mit Wasserstoff. Die Erfindung betrifft auch ein Linsenelement aus Quarzglas sowie ein Projektionsobjektiv, insbesondere für die Immersionslithographie, mit mindestens einem solchen Linsenelement.

Optische Elemente, z.B. Linsenelemente, aus Quarzglas kommen beispielsweise in Projektionsbelichtungsanlagen für die Mikrolithographie bei Wellenlängen im UV-Bereich zum Einsatz. Derartige Linsenelemente werden typischer Weise durch mechanisches Bearbeiten eines Rohlings aus einem synthetischen Quarzglas hergestellt. Das synthetische Quarzglas des Rohlings wird durch Verbrennen einer siliziumhaltigen, organischen oder anorganischen Precursor-Substanz in H₂ und O₂, ggf. unter Zusatz eines Heizgases wie etwa Erdgas, hergestellt. In der Flamme bilden sich bereits SiO₂-Partikel, die auf einem Target abgeschieden werden. Bei der Quarzglasherstellung unterscheidet man zwischen dem so genannten direkten Prozess, bei dem eine sehr heiße Flamme auf ein heißes Target gerichtet wird, so dass die Partikel direkt verglasen und dem so genannten Soot-Prozess, bei dem sich bei geringeren Temperaturen ein poröser Körper abscheidet, der nach Trocknung und ggf. Dotierung zu einem massiven Glaskörper gesintert wird.

Defekte in der Glasmatrix des Quarzglases, etwa fehlende Bindungen der Form O-Si· oder O-Si-O, Peroxy-Defekte der Form Si-O-O-Si und ODC (engl. "oxygen deficient centers") der Form O-Si-Si-O oder auch einfach nur geschwächte Matrixbindungen (engl. "strained bonds") bestehen nach der Herstellung des Quarzglases je nach Prozessführung in unterschiedlichem Ausmaß. Die beiden erstgenannten Defekte können zudem unter Laserbestrahlung bei der späteren Nutzung als optisches Element durch das Aufbrechen geschwächter Matrixbindungen oder von Peroxy- oder ODC-Defekten entstehen. Alle genannten Defekte zeichnen sich durch starke Absorptionsbanden im UV-Wellenlängenbereich aus, manche werden sogar mit laserinduzierten Dichteänderungen wie "Compaction" in Verbindung gebracht.

Absorptionsbanden im UV-Bereich sind für die Verwendung von Quarzglas bzw. von aus Quarzglas hergestellten Linsenelementen in der Mikrolithographie ungünstig, da dort Strahlung eines üblicherweise gepulsten Lasers bei einer Betriebswellenlänge im UV-Wellenlängenbereich verwendet wird, und zwar typischer Weise Strahlung bei einer Wellenlänge von ca. 193 nm (ArF-Laser). Wasserstoff (oder schwerer Wasserstoff, d.h. Deuterium) kann die beiden erstgenannten Defekte zu O-Si-H bzw. O-Si-OH (bzw. zu O-Si-D bzw. O-Si-DH) absättigen, welche nur noch eine schwache Absorption im UV-Bereich aufweisen.

Bei direkt abgeschiedenem Quarzglas für den Einsatz im UV-Wellenlängenbereich wird die Flammenstöchiometrie typischer Weise so eingestellt, dass ein Wasserstoff-Überschuss besteht und molekularer Wasserstoff im Bereich zwischen ca. 5 x 10¹⁶ bis 10¹⁹ Molekülen/cm³ in das Quarzglas eingebaut wird. Gleichzeitig stellt sich zwangsläufig ein OH-Gehalt zwischen ca. 600 und 1300 ppm (nach Gewicht) in dem Quarzglasmaterial ein.

Da beim direkten Abscheiden der Wasserstoff heiß eingebracht wird, ergibt sich ein hoher Silan(SiH)-Gehalt. Derartige Quarzgläser werden für Lithographie-Systeme bei einer Betriebswellenlänge von ca. 193 nm, insbesondere für die Immersionslithographie, in der Regel nicht mehr eingesetzt, da sie starke polarisationsinduzierte Doppelbrechung und Compaction (Dichteerhöhung) bei der Bestrahlung mit höheren und Rarefaction (Dichteverringerung) bei der Bestrahlung mit geringeren Energiedichten aufweisen. Bezüglich der Herstellung eines solchen Quarzglasmaterials sei beispielhaft auf die US 7,265,070 B2, WO 02/29492 A1 und die US 7,064,093 B2 verwiesen.

Zeitweise wurde an Stelle von direkt abgeschiedenem Quarzglas ungetrocknetes Soot-Glas mit einem OH-Gehalt um ca. 250 ppm (nach Gewicht) oder darüber eingesetzt, das unter Inertgas (erste Generation) oder Wasserstoff-Atmosphäre (zweite Generation) gesintert wurde (vgl. US 7,082,790 B2 oder DE 198 41 932 A1). Da der hohe OH-Gehalt der Bildung von SiH entgegen wirkt, konnte solches vergleichsweise trockenes Glas nur auf deutlich geringere Wasserstoff-Gehalte dotiert werden als direkt abgeschiedenes Quarzglas.

Heutzutage werden für Lithographiesysteme, die bei einer Wellenlänge von ca. 193 nm betrieben werden, in der Regel nur noch Soot-Gläser der dritten Generation verwendet, die auf OH-Gehalte von typischer Weise ca. 0,1 ppm bis 100 ppm oder 200 ppm getrocknet, gesintert, entspannungsgetempert und erst dann bei "kalten" Temperaturen von maximal 600°, normalerweise aber ca. 400°C bis 500°C mit Wasserstoff beladen werden. Derartige Soot-Gläser weisen eine um einen Faktor 2-3 geringere Compaction und um Größenordnungen geringere FDT (engl. "fluence dependent transmission"), polarisationsinduzierte Doppelbrechung und Rarefaction als direkt abgeschiedene Gläser oder Soot-Gläser erster oder zweiter Generation auf, vgl. dazu beispielsweise: US 7,501,367 B2, DE 10 2004 017 031 B4, US 7,534,733 B2, US 7,928,026 B2, US 7,589,039 B2.

Die kalte Beladung, d.h. die Beladung des Quarzglasrohlings mit Wasserstoff bei niedrigen Temperaturen, bedingt lange Beladezeiten von mehreren Monaten für 5 bis 10 cm dicke Rohlinge, je nach notwendigem Wasserstoff-Gehalt in der Mitte des Rohlings und zulässigem Wasserstoff-Gradienten im Volumen des Rohlings. Bei längerer Beladedauer diffundiert mehr Wasserstoff in die Mitte des Rohlings, so dass der Gradient der Wasserstoff-Ortsverteilung im Rohling mit zunehmender Beladungsdauer abnimmt.

Die Diffusionszeit des Wasserstoffs in das Quarzglasmaterial lässt sich zwar etwas verkürzen, indem ein Autoklav verwendet wird, in dem Wasserstoff bei einem Druck von mehr als 1 bar bei der Solltemperatur gehalten werden darf. Ein solcher Autoklav löst das Problem zu großer Beladedauer jedoch nur bedingt, denn schon bei einem Druck von 2 bar ergibt sich je nach verwendeter Beladetemperatur ein Wasserstoff-Gehalt in den Randbereichen des Rohlings von nahezu 1 x 10¹⁸ Molekülen/cm³. Wenn der benötigte Wasserstoff-Gehalt in der Mitte des Rohlings eine Größenordnung niedriger ist, weil dort aufgrund der Laserbelastung nicht mehr Wasserstoff benötigt wird und die Beladezeit möglichst kurz gehalten werden soll, ergibt sich bereits eine Brechzahldifferenz bei einer Wellenlänge von 193 nm von ca. 3 ppm zwischen Mitte und Rand des (zylindrischen) Rohlings sowohl entlang der Zylinderachse als auch quer dazu. Diese Brechzahldifferenz liegt jedoch in derselben Größenordnung wie oder ist bereits größer als die zulässige Brechzahl-Inhomogenität eines Quarzglases für Lithographie-Anwendungen.

Es sind zwei Verfahren bekannt, um die Beladezeit dennoch zu verkürzen: Bei einem ersten Verfahren, welches z.B. in der US 6,810,687 B2 und der US 7,994,083 B2 beschreiben ist, wird der Partialdruck bei der Beladung über die Zeit variiert. Die Beladung kann beispielsweise mit einem kurzen Beladeschritt bei mehr als 100% Wasserstoff-Partialdruck bezogen auf 1 bar Umgebungsdruck, also z.B. 100% Wasserstoff (H₂) bezogen auf 10 bar Umgebungsdruck, entsprechend 1000% Partialdruck bezogen auf Normalbedingungen, beginnen. Dadurch wird ein sehr hoher Wasserstoff-Gehalt in die Außenbereiche des Rohlings aus Quarzglas gedrückt. Danach wird diese Wasserstoffmenge durch Lagerung unter Normaldruck weiter in den Rohling hinein verteilt. Sofern die Lagerung nicht unter einer Wasserstoff-Atmosphäre erfolgt, ist noch ein dritter Schritt erforderlich, in dem wieder etwas Wasserstoff in die nach der Temperung mit 0% Partialdruck wasserstofffreien Außenbereiche des Rohlings diffundiert wird.

Der US 6,810,687 B2 und der US 7,994,083 B2 ist gemeinsam, dass alle Belade- und Temper- bzw. Ausfließschritte bei gleichbleibender Temperatur ausgeführt werden. Ziel dieser Druckschriften ist es im Wesentlichen, die Aufenthaltsdauer im teuren Druckbeladeofen bzw. beim dreiteiligen Verfahren auch die Aufenthaltsdauer im drucklosen Wasserstoff-Ofen zu verkürzen. Die erzielbare Verkürzung der Gesamtdurchlaufzeit gegenüber Beladung bei gleichbleibendem Druck liegt je nach Geometrie des Rohlings und Vorgaben zu Wasserstoff-Gehalten und zulässigen Gradienten in der Größenordnung von ca. 20%. Auch tritt bei diesen Verfahren das Maximum des Wasserstoff-Gehalts nicht an den Oberflächen des Rohlings, sondern weiter innen auf, wo der hohe Wasserstoff-Gehalt in der Regel nicht benötigt wird. So tritt im Glas-Volumen lokal ein erhöhter SiH-Gehalt auf und in z-Richtung (in Richtung der optischen Achse) werden in dem Rohling vier Flanken der Brechzahländerung statt zweier durchlaufen, was zu erhöhten Bildfehlern führt.

Ein weiteres Verfahren zur Verkürzung der Beladezeit, welches in der DE 10 2007 022 881 A1 beschrieben ist, sieht vor, den Rohling erst mechanisch auf eine Geometrie nahe der Endgeometrie zu bearbeiten und nachfolgend mit Wasserstoff zu beladen. Da die Beladezeit des Rohlings für gleichen Wasserstoff-Gehalt in der Mitte des Rohlings und gleiche zulässige Wasserstoff-Gradienten mit dem Quadrat der Dicke des Rohlings zunimmt, lässt sich die Beladezeit für eine typische Meniskuslinse, deren lokale Dicke überall ungefähr der halben Höhe des umschreibenden Zylinders entspricht, um den Faktor 4 verkürzen. Dieses Verfahren bringt jedoch bei allen anderen Linsenformen (bikonvex, bikonkav, plankonkav, plankonvex) nur geringe Vorteile, da hier die lokale Dicke nur unwesentlich unter der Dicke des ursprünglichen zylindrischen Rohlings liegt, aus dem das entsprechende Linsenelement hergestellt wird.

In der US 2011/0021339 A1 wird ein Verfahren zum Erzeugen eines Bauteils aus Quarzglas beschrieben, welches bei Wellenlängen von weniger als 250 nm eine saturierte induzierte Absorption aufweisen soll. Um dies zu erreichen, werden in einem ersten Schritt Si-O-Defekte in dem Quarzglas entfernt, indem an diesen Defekten Silan (SiH) gebildet wird. Zur Bildung des Silans wird das Quarzglas bei Temperaturen von mehr als 475°C mit molekularem Wasserstoff beladen. Nach der Bildung des Silans wird das Quarzglas bei Temperaturen von weniger als 475°C mit zusätzlichem molekularen Wasserstoff in hohen Konzentrationen ab 5 x 10¹⁶ Molekülen/cm³ beladen, um eine Umwandlung von E'-Defektzentren, die bei der Bestrahlung des Silans mit Laserstrahlung entstehen, in Silan zu unterstützen, d.h. das Reaktionsgleichgewicht SiH + Photon <-> Si· + H soll möglichst auf der linken Seite verbleiben.

In der JP 2009 190958 A wird ein Beladeprozess eines Rohlings mit Wasserstoff beschrieben, der mindestens zwei Schritte umfasst, wobei in einem ersten Schritt der Rohling bei einer Temperatur von 350°C bis 450°C und bei einem Wasserstoff-Partialdruck von 0,5 bis 1,5 MPa beladen wird und wobei in einem zweiten Schritt der Rohling bei einer Temperatur von 350°C bis 450°C und bei einem Wasserstoff-Partialdruck von 0,05 bis 0,5 MPa beladen wird.

### Aufgabe der Erfindung

Aufgabe der Erfindung ist es, ein Verfahren zum Beladen eines Quarzglasrohlings mit Wasserstoff zu optimieren und insbesondere die Beladedauer zu verkürzen, sowie ein Linsenelement und ein Projektionsobjektiv mit mindestens einem solchen Linsenelement mit verbesserten optischen Eigenschaften anzugeben.

### Gegenstand der Erfindung

Diese Aufgabe wird gelöst durch ein Verfahren der eingangs genannten Art, bei dem das Beladen mit Wasserstoff mindestens zwei Schritte umfasst, wobei in dem ersten Schritt der Rohling bei einer ersten Temperatur und einem ersten Wasserstoff-Partialdruck und in dem zweiten Schritt bei einer zweiten, von der ersten verschiedenen Temperatur und einem zweiten, vom ersten verschiedenen Wasserstoff-Partialdruck beladen wird, wobei die erste Temperatur und die zweite Temperatur kleiner als eine Grenztemperatur sind, bei der eine thermische Bildung von Silan in dem Quarzglas-Material des Rohlings einsetzt, und wobei in dem zweiten Schritt der Rohling bei einer geringeren Temperatur beladen wird als in dem ersten Schritt.

Unter dem Begriff Wasserstoff bzw. unter der Bezeichnung H (oder OH) werden im Sinne dieser Anmeldung alle Isotope von Wasserstoff (Protium, Deuterium, Tritium) verstanden, sofern nichts anderes angegeben ist. Insbesondere Deuterium (D₂) kann neben Protium (H₂) ebenfalls für die Beladung mit Wasserstoff verwendet werden. Typischer Weise erfolgt die Beladung nur mit einem der Wasserstoff-Isotope, d.h. entweder mit H₂ oder mit D₂, eine Beladung mit Mischungen der beiden (oder ggf. mit Tritium T₂) ist aber ebenso möglich. Im letzteren Fall bezieht sich der Wasserstoff-Partialdruck auf die Summe aus dem H₂-Partialdruck, dem D₂-Partialdruck und ggf. dem T₂-Partialdruck. Unter dem Begriff Silan wird im Sinne dieser Anmeldung kein molekulares Silan (SiH) verstanden, sondern Si-H-Bindungen bzw. Si-H-Gruppen, die sich in der SiO₂-Glasmatrix unter bestimmten Bedingungen ausbilden. Wie in der eingangs zitierten US 2011/0021339 A1 wird auch in der vorliegenden Anmeldung unter dem Silan-Gehalt des Quarzglases die Anzahl der Si-H-Bindungen pro Volumenelement (typischer Weise: pro cm³) verstanden.

Mit Ausnahme des in der US 2011/0021339 A1 beschriebenen Verfahrens wurden bislang nur Beladeverfahren verwendet und beschrieben, bei denen für jeden Rohling eine konstante Beladetemperatur verwendet wird, nämlich die für die jeweilige Anwendung (Glassorte, Objektivtyp, Linsenposition etc.) maximal zulässige (qualifizierte) Temperatur. Diese maximale Beladetemperatur wird in der Regel festgelegt durch die Anforderung, nur eine geringe Menge an Silan (SiH) und ODC zuzulassen. Der Silangehalt eines Quarzglases lässt sich direkt, z.B. durch Raman-Spektroskopie, nur schwer ermitteln, da die Nachweisgrenze bei der Raman-Spektroskopie zu hoch ist. Der Silangehalt hat aber direkten Einfluss auf die so genannte "fluence dependent transmission", FDT, also auf die Einstellung eines dynamischen Absorptionsgleichgewichts als Funktion der Energiedichte, wie beispielsweise in der US 7,928,026 B2 beschrieben ist. Die FDT wird dort in Abhängigkeit von der transienten Absorption K (in cm⁻¹) des Quarzglases im UV-Bereich und der Fluenz F, d.h. der Energiedichte (in mJ/cm / Puls), angegeben, und zwar als die Steigung dK/dF (in cm x Puls / mJ) einer mittels der Methode kleinster Fehlerquadrate ermittelten linearen Approximationskurve der Absorption K in Abhängigkeit von der Energiedichte F.

Bei einem zu großen Silangehalt (entsprechend einer zu großen FDT-Steigung) bricht die Transmission einer optischen Anordnung, in der ein optisches Element aus einem entsprechenden Quarzglasmaterial eingesetzt wird, während der ersten Sekunden und Minuten des Betriebs ein (Effizienzverlust) und bei jeder Nutzungspause oder Änderung des Betriebsmodus wird sich über die nächsten Minuten ein neuer Gleichgewichtszustand einstellen. Beim Betrieb einer optischen Anordnung in Form einer Projektionsbelichtungsanlage erschwert dies z.B. die Steuerung der Belichtungsdosis auf dem Photoresist (auf dem Wafer) erheblich. Ferner ist bekannt, dass sich bei erhöhter SiH- oder ODC-Konzentration auch die Lebensdauer-Eigenschaften wie z.B. Compaction des Quarzglases verschlechtern.

Die sich einstellende Defektkonzentration (SiH oder FDT-Steigung und ODC) hängt u.a. vom Grundglas ab, genauer gesagt von dessen OH-Gehalt und von der Art und Konzentration der Vorgängerdefekte. Für ein gegebenes Grundglas (vor der Beladung) stellen sich umso mehr Defekte nach der Beladung ein je höher die Beladetemperatur und die Wasserstoffkonzentration nach der Beladung sind. Theoretisch hat auch die Beladedauer (d.h. das ortsaufgelöste Konzentrationsintegral über die Zeit der Beladung) einen Einfluss, diese scheint aber praktisch nur einen geringen Einfluss zu haben.

In Fig. 2 der US 7,928,026 B2 sind für OH-arme Gläser (<= 100 ppm nach Gewicht) drei Bereiche der Beladetemperatur gezeigt: Für Temperaturen deutlich unter 550° (erster Bereich) ergibt sich ein extrem flacher Anstieg der FDT-Steigung mit der Temperatur (quasi an der Messgrenze), im Bereich 600 - 700°C (zweiter Bereich) zeigt sich ein steiler Anstieg und oberhalb von 700° (dritter Bereich) ist der Anstieg wieder geringer, aber noch deutlich messtechnisch auflösbar. Für Quarzgläser mit einem höheren OH-Gehalt (mehr als 550 ppm) ist nur der erste Bereich dargestellt, da sich der zweite und der dritte Bereich zu höheren Temperaturen verschieben. Die dargestellten Grenzen der Bereiche für OH-armes Quarzglas gelten nicht allgemein, sondern sind von der Defektdichte und der Art der Defekte abhängig, wie sich aus Tabelle 1 der US 7,928,026 B2 ergibt.

Die maximale (qualifizierte) Beladetemperatur für ein Quarzglasmaterial mit gewünschten vorgegebenen Eigenschaften (OH-Gehalt, H₂-Gehalt nach dem Beladen, etc.) wird typischer Weise so gewählt, dass diese unterhalb einer Grenztemperatur liegt, an welcher der FDT-Wert deutlich ansteigt (d.h. die Grenztemperatur liegt vor dem Übergang vom ersten in den zweiten Bereich) und somit die thermische Bildung von Silan deutlich zunimmt. Um einen ausreichenden Sicherheitsabstand zu gewährleisten, wird die im Herstellprozeß maximal zulässige (qualifizierte) Beladetemperatur typischer Weise etwas niedriger gewählt als die Grenztemperatur.

In der US 2011/0021339 A1, die eine andere Zielsetzung (Herstellung eines Glases mit nicht veränderlicher Absorption anstelle von Glas mit möglichst wenig Silan) hat, wird hingegen eine Beladung mit Wasserstoff in zwei Schritten beschrieben, wobei der erste Schritt bei einer Temperatur von mehr als 475°C erfolgt, bei der gemäß der Lehre der US 2011/0021339 A1 eine signifikante bzw. vollständige Umwandlung gestresster Bindungen in thermisches Silan in dem Quarzglasmaterial stattfindet.

Erfindungsgemäß wird ein mehrstufiges Beladeverfahren vorgeschlagen, bei dem die Temperatur und der Partialdruck beim Beladen in mindestens zwei Beladungsschritten unterschiedlich gewählt werden, wobei die Temperaturen in den beiden Beladeschritten kleiner gewählt werden als die Grenztemperatur, bei der die thermische Bildung von Silan in dem Quarzglas-Material des Rohlings einsetzt bzw. bei der die thermische Bildung von Silan signifikant zunimmt. Die Partialdrücke in den beiden Beladungsschritten werden hierbei typischer Weise derart aufeinander abgestimmt, dass sich bei einer wirtschaftlich vertretbaren Beladungsdauer des gesamten Beladungsprozesses (d.h. der Summe der Zeitdauern der Beladungsschritte) der gewünschte Wasserstoff- oder Deuterium-Gehalt in der Mitte des Rohlings einstellt. Durch ein mehrstufiges Beladeverfahren mit einer Variation der Temperatur (und des Partialdrucks) lässt sich über große Teile der Dicke des Rohlings eine vergleichsweise geringe H₂-Konzentration erzeugen, verbunden mit einer relativ geringen SiH-Konzentration.

Die Beladungsdauer des ersten Beladungsschritts kann insbesondere so gewählt werden, dass sich nach Beendigung dieses ersten Schrittes in der Mitte des Rohlings nur ca. 80-90% des Soll-Gehalts an H₂ einstellen. Da der Wasserstoff während des zweiten Beladungsschritts weiter in den Rohling hinein diffundiert, kann typischer Weise auch in diesem Fall der Soll-Gehalt an Wasserstoff in der Mitte des Rohlings am Ende des zweiten Beladungsschritts erreicht werden.

In dem zweiten Schritt wird der Rohling bei einer geringeren Temperatur beladen als in dem ersten Schritt. Die Temperatur in dem zweiten Schritt kann insbesondere (deutlich) niedriger gewählt werden als die maximal zulässige (konstante) Temperatur bei der konventionellen Beladung. Auf diese Weise kann in den Außenbereichen des Rohlings bei geeignetem Wasserstoff-Partialdruck bzw. bei einer vergleichsweise geringen Beladungsdauer eine hohe H₂-Konzentration erzeugt werden, wobei sich wegen der geringen Temperatur bei der Beladung trotz des hohen H₂-Gehalts in den Randbereichen nur eine geringe Erhöhung des SiH-Gehalts von maximal einigen 10 % einstellt, d.h. die Erhöhung des Silan-Gehalts ist deutlich geringer als bei einer konventionellen Beladung mit konstanter Temperatur. Durch den ersten Schritt, der bei höherer Temperatur durchgeführt wird, kann erreicht werden, dass die Beladungsdauer insgesamt nicht zu groß und die Beladung damit unwirtschaftlich wird.

Bei einer vorteilhaften Variante wird der Rohling in dem zweiten Schritt bei einem höheren Wasserstoff-Partialdruck beladen als in dem ersten Schritt. Durch die Beladung mit einem hohen Wasserstoff-Partialdruck kann bei vergleichsweise geringer Beladungsdauer ein hoher H₂-Gehalt in den Außenbereichen des Quarzglasrohlings erzeugt werden. Wie weiter oben dargestellt wurde, können die Partialdrücke in den beiden Beladungsschritten so aufeinander abgestimmt werden, dass bei einer möglichst geringen Gesamt-Beladungsdauer eine gewünschte Wasserstoff-Verteilung im Volumen des Rohlings erzeugt wird.

Bei einer weiteren Variante wird in einem dem Beladen vorausgehenden Schritt die Grenztemperatur bestimmt, bei dem die thermische Bildung von Silan in dem Quarzglas des Rohlings einsetzt bzw. signifikant zunimmt. Wie weiter oben dargestellt wurde, hängt die Defektkonzentration bzw. die Anzahl und Verteilung der Bindungsenergien der geschwächten Bindungen des Grundglases (d.h. des Quarzglases vor der Beladung) vom Herstellungsweg des Grundglases sowie von dessen Materialeigenschaften, insbesondere von dessen OH-Gehalt, ab. Für die Bestimmung der Grenztemperatur wird zunächst für ein Grundglas (vor der Beladung) ein der späteren Anwendung angemessener Wasserstoff-Gehalt festgelegt, der von der maximal erwarteten Energiedichte und Pulszahl auf dem Linsenelement abhängig ist, das aus dem Rohling gefertigt werden soll. Dann werden Proben bzw. Rohlinge hergestellt, die bei unterschiedlichen Temperaturen mit Wasserstoff beladen werden, bis der vorgegebenen Mindest-Wasserstoff-Gehalt (bzw. eine Mindest-Verteilung) erreicht ist. Nachfolgend wird der Silan-Gehalt der beladenen Proben bestimmt, um die Grenztemperatur zu identifizieren, oberhalb derer der Silan-Gehalt deutlich ansteigt. Für die Beladung eines Rohlings aus einem Grundglas, welches dieselben Eigenschaften und denselben Herstellungsprozess wie die Proben durchlaufen hat, wird eine Temperatur für die Beladung festgelegt, die kleiner ist als die Grenztemperatur bzw. die einen ausreichenden Abstand zur Grenztemperatur aufweist.

Bei einer Weiterbildung dieser Variante wird die Grenztemperatur anhand einer Änderung dK / dF des Absorptionskoeffizienten K des Quarzglases des Rohlings in Abhängigkeit von der Energiedichte F bei der Bestrahlung mit gepulster Laserstrahlung bei einer Wellenlänge von 193 nm bestimmt, wie dies in der US 7,928,026 B2 beschrieben ist. Hierbei wird ausgenutzt, dass der Silangehalt einen direkten Einfluss auf die Steigung dK / dF hat, so dass eine hoher Wert für die Steigung dK / dF ein Indikator für einen hohen Silan-Gehalt ist. Als Grenztemperatur kann beispielsweise diejenige Temperatur festgelegt werden, bei welcher die Steigung dK / dF noch unterhalb eines Schwellwerts liegt, der beispielsweise bei ca. 5 x 10⁻⁴ cm x Puls / mJ liegen kann. Es versteht sich, dass auch geringere Steigungen dK / dF, z.B. 1 x 10⁻⁴ cm x Puls / mJ, 5 x 10⁻⁵ cm x Puls / mJ oder 1 x 10⁻⁵ cm x Puls / mJ als Schwellwerte für die Bestimmung der Grenztemperatur gewählt werden können.

Bei einer Variante wird der Rohling in dem ersten Schritt bei einer Temperatur von weniger als 475°C, bevorzugt von weniger als 450°C beladen. Die Beladung in dem ersten Schritt kann insbesondere bei der maximalen (qualifizierten) Beladetemperatur für die jeweilige Glasart (OH-Gehalt etc.) durchgeführt werden, d.h. bei einer Temperatur, die nur unwesentlich unter der Grenztemperatur (Übergang zwischen dem ersten und zweiten Bereich in Fig. 2 in der US 7,928,026 B2) liegt. Insbesondere bei Quarzglas mit geringem OH-Gehalt sollte typischer Weise eine Grenztemperatur von 475°C nicht überschritten werden. Da die Grenztemperatur mit zunehmendem OH-Gehalt zunimmt, kann jedoch bei Quarzgläsern mit hohem OH-Gehalt (> 100 ppm) der erste Schritt ggf. auch bei einer vergleichsweise hohen Temperatur (z.B. 600°C oder mehr) durchgeführt werden. In diesem Fall sollte allerdings eine Qualifikation des Quarzglas-Materials durch den oben beschriebenen FDT-Test erfolgen, damit sichergestellt ist, dass die Grenztemperatur nicht überschritten wird. Eine hohe Beladetemperatur im ersten Schritt ist ggf. auch günstig, wenn das Quarzglas bzw. das aus diesem gefertigte Linsenelement nur einer vergleichsweise geringen Energiedichte ausgesetzt ist, so dass der Wasserstoff-Gehalt in der Mitte des Rohlings vergleichsweise niedrig angesetzt werden kann. Je geringer der Partialdruck des Wasserstoffs im ersten Schritt gewählt wird, desto höher kann die Beladetemperatur im ersten Schritt gewählt werden.

In einer weiteren Variante wird der Rohling in dem zweiten Schritt bei einer Temperatur von weniger als 400°C, bevorzugt von weniger als 300°C beladen. Die Temperatur in dem zweiten Schritt kann insbesondere bei weniger als 350°C, 300°C, 250°C, 200°C oder ggf. darunter liegen. Die herkömmliche, einstufige Beladung mit Wasserstoff wird in der Regel nicht bei Temperaturen von weniger als ca. 400°C durchgeführt, da diese bei vergleichsweise dicken Rohlingen zu Beladezeiten in der Größenordnung von ca. einem Jahr oder mehr führen können. Bei der hier beschriebenen zweistufigen Beladung kann durch die Wahl eines vergleichsweise hohen Partialdrucks im zweiten Schritt auch bei vergleichsweise geringer Temperatur ein hoher H₂-Gehalt in die Außenbereiche des Rohlings eingebracht werden.

In einer Variante wird der Rohling in dem ersten Schritt bei einem Wasserstoff-Partialdruck von 20% oder weniger, bevorzugt von 10% oder weniger beladen. Der Partialdruck, unter dem der Rohling mit Wasserstoff beladen wird, beeinflusst (ebenso wie die Beladungsdauer) die Verteilung des Wasserstoffs über das Volumen des Rohlings. Ein vergleichsweise niedriger Partialdruck von ca. 20% oder ca. 10% führt auch bei einer nicht zu großen Beladungsdauer zu einer vergleichsweise homogenen Wasserstoff-Verteilung in dem Rohling, d.h. zu einer Verteilung, bei welcher der Wasserstoff-Gehalt in den Außenbereichen des Rohlings nur geringfügig größer als in der Mitte des Rohlings ist. Der oben angegebene Wasserstoff-Partialdruck (in %) ist bezogen auf Normalbedingungen bzw. auf Normaldruck, d.h. auf 1 bar. Ein Wasserstoff-Partialdruck von mehr als 100%, z.B. 1000%, ist daher möglich, letzterer entspricht einem Wasserstoff-Gehalt von 100% bei 10 bar in der Beladeatmosphäre des Ofens.

Bei einer weiteren Variante wird der Rohling in dem zweiten Schritt bei einem Wasserstoff-Partialdruck von mehr als 50%, bevorzugt von mehr als 90%, besonders bevorzugt von mehr als 100% beladen. Die Beladung bei einem hohen Wasserstoff-Partialdruck führt dazu, dass bei gleicher Beladungsdauer die Differenz zwischen dem Wasserstoff-Gehalt in den Außenbereichen des Rohlings zur Mitte des Rohlings größer ausfällt als bei einem niedrigeren Partialdruck. Bei der Verwendung eines Autoklavs, in dem die Beladung mit Wasserstoff bei einem Druck von mehr als 1 bar erfolgen kann ist es ggf. auch möglich, den zweiten Schritt bei einem Wasserstoff-Partialdruck von mehr als 100%, beispielsweise von 200% (d.h. 100% bei 2 bar) vorzunehmen.

Typischer Weise wird die oben beschriebene Beladung an einem Quarzglas-Rohling vorgenommen, der in einem Soot-Prozess hergestellt wurde. Ein solcher Rohling weist typischer Weise einen geringen OH-Gehalt auf, der beispielsweise bei weniger als 200 ppm nach Gewicht, weniger als 100 ppm nach Gewicht, weniger als 50 ppm nach Gewicht, weniger als 20 ppm nach Gewicht, weniger als 10 ppm nach Gewicht, weniger als 5 ppm nach Gewicht oder weniger als 1 ppm nach Gewicht liegen kann.

Es versteht sich, dass gegebenenfalls innerhalb eines Beladungsschritts (mit konstanter Temperatur) der Wasserstoff-Partialdruck variiert werden kann, wie dies beispielsweise in der eingangs zitierten US 6,810,687 B2 bzw. US 7,994,083 B2 beschrieben ist. Auch kann ggf. der Rohling vor der Beladung bereits mechanisch bearbeitet und auf diese Weise eine Geometrie erzeugt werden, die an die Geometrie des aus dem Rohling zu fertigenden Linsenelements angepasst ist, wie dies in der DE 10 2007 022 881 A1 beschrieben ist. Wie weiter oben dargestellt wurde, kann auf diese Weise insbesondere bei einem Linsenelement in Form einer Meniskuslinse die Beladezeit deutlich reduziert werden.

Es versteht sich, dass zwischen dem ersten und dem zweiten Beladungsschritt die Temperatur auf Raumtemperatur abfallen darf, da bei Raumtemperatur in der Regel keine relevante Diffusion von Wasserstoff innerhalb des Volumens des Rohlings mehr stattfindet. Es ist daher nicht erforderlich, dass der zweite Beladungsschritt unmittelbar auf den ersten Beladungsschritt folgt, so dass die Rohlinge zwischen dem ersten und dem zweiten Schritt gelagert werden können. Auf diese Weise können mehrere Rohlinge gesammelt werden, um in einer gemeinsamen Charge dem zweiten Beladungsschritt in einem Ofen unterworfen zu werden.

Ein weiterer Aspekt der Erfindung betrifft ein Linsenelement aus Quarzglas, an dem eine Oberfläche und eine weitere Oberfläche zum Durchtritt von Strahlung gebildet sind, wobei das Linsenelement bis zu einem Abstand von 1 mm zur Oberfläche einen Gehalt an Wasserstoff von mindestens 5 x 10¹⁶ Molekülen / cm³, bevorzugt von mindestens 5 x 10¹⁷ Molekülen / cm³, insbesondere von mindestens 10 x 10¹⁷ Molekülen / cm³ aufweist, wobei der Gehalt an Wasserstoff im Volumen des Linsenelements auf einen minimalen Wert von 10% oder weniger des Gehalts an Wasserstoff an der Oberfläche - insbesondere monoton - abfällt, und wobei der Wasserstoff-Gehalt bis zu einem Abstand von 8 mm zur Oberfläche auf 50% oder weniger des Wasserstoff-Gehalts an der Oberfläche abfällt, und wobei an allen Stellen im Volumen des Linsenelements der Silan-Gehalt bei weniger als 5 x 10¹⁴ Molekülen/cm³ liegt. Bei der Oberfläche kann es sich insbesondere um eine im Wesentlichen plane Lichtaustrittsfläche eines letzten Linsenelements eines Projektionsobjektivs für die Immersionslithographie handeln.

Bevorzugt variiert der Silan-Gehalt über die Dicke des Linsenelements um nicht mehr als 50%, besonders bevorzugt um nicht mehr als 30%, insbesondere um nicht mehr als 20%. Da im zweiten Schritt praktisch kein Silan mehr gebildet wird, hängt die Variation des Silan-Gehalts nur davon ab, wie groß das Verhältnis aus maximalem und minimalem Silan-Gehalt nach dem ersten Beladeschritt ausfällt. Dieses Verhältnis kann durch die Dauer des ersten Beladeschrittes eingestellt werden, wobei längere Beladedauern im ersten Schritt zu einer kleineren Variation des Silan-Gehalts führen. Je geringer der Partialdruck des Wasserstoffs im ersten Schritt gewählt wird, desto höher kann die Beladetemperatur im ersten Schritt gewählt werden.

Die Linsenelemente in einem optischen System, beispielsweise einem Scanner für die Halbleiterlithographie, stehen häufig entweder in einem konvergenten oder einem divergenten Strahl. Zur Erläuterung wird ein Lichtbündel, das von einem Punkt auf der Maske ausgeht und auf den Wafer abgebildet wird (ggf. aber auch für Linsenelemente im Beleuchtungssystem, auch wenn dort keine Abbildung erfolgt) betrachtet. Durch die Anordnung im konvergenten bzw. divergenten Strahlengang ist der Durchmesser des Lichtbündels auf einer der beiden Linsenoberflächen typischer Weise kleiner als auf der anderen. Die höchsten Energiedichten auf den Linsenelementen werden in der Regel mit Dipol- oder Quadrupol-Beleuchtungseinstellungen erreicht, in denen jedes Linsenelement in seinem Randbereich von zwei bzw. vier kleinen Lichtbündeln durchstrahlt wird.

Da die Energiedichte im Linsenelement mit dem Quadrat des Durchmessers des durch das Linsenelement hindurch tretenden (ggf. elliptisch geformten) Lichtbündels zunimmt, ergibt sich bei einem Unterschied der Durchmesser des Lichtbündels auf den beiden mit Strahlung beaufschlagten Linsenoberflächen von ca. 1,41 ein Faktor 2 in der Energiedichte. Da der Wasserstoffbedarf bei den meisten Quarzglas-Materialien mit dem Quadrat der Energiedichte im jeweiligen durchstrahlten Volumen zunimmt, ergibt sich bei einem solchen Unterschied zwischen den Durchmessern der Lichtbündel an den Oberflächen des Linsenelements in der Mitte des Linsenelements ein um ca. den Faktor 4 geringerer Wasserstoffbedarf als an derjenigen Oberfläche des Linsenelements mit dem kleineren Strahldurchmesser. Falls es sich bei dieser Oberfläche um eine konkave, eine plane oder eine nur geringfügig konvexe Fläche handelt, wird sich der Ort der höchsten Energiedichte in der Nähe der Seitenfläche (typischer Weise am Übergang von der Seitenfläche zur Stirnseite) des ursprünglichen Rohlings befinden, d.h. am Ort des maximalen Wasserstoff-Gehalts. Für stark konvexe Linsenoberflächen ist eine mechanische Vorbearbeitung des Rohlings vor dem Beladen günstig, wie sie in der DE 10 2007 022 881 A1 beschrieben ist, da nach der Vorbearbeitung die konvex gekrümmte Linsenoberfläche im Wesentlichen mit dem Rand des vorbearbeiteten Rohlings übereinstimmt.

Das letzte Linsenelement eines Immersionssystems für die Mikrolithographie ist typischer Weise eine Plankonvexlinse, d.h. dieses weist eine in der Regel plane Austrittsfläche auf. Durch die große numerische Apertur (NA > 1,3) ergibt sich ein Unterschied zwischen der Energiedichte in der Mittelebene des Rohlings, aus dem das Linsenelement hergestellt wird, und dem Bereich der Austrittsfläche von mehr als 1:5 und somit ein Unterschied im H₂-Bedarf von typischer Weise mehr als ca. 1:25. Daher ist es günstig, ein solches Linsenelement mit einer Verteilung des Wasserstoff-Gehalts zu versehen, die ausgehend von der (planen) Austrittsfläche, an welcher aufgrund der dort auftretenden hohen Energiedichten von ca. 0,5 mJ /cm² / Puls ein hoher Wasserstoff-Gehalt erforderlich ist, den Wasserstoff-Gehalt bis zur Mitte des Linsenelements deutlich (um mindestens einen Faktor 10, ggf. einen Faktor 15, 20 oder mehr) zu reduzieren. Durch den oben beschriebenen zweistufigen Beladeprozess fällt die Änderung des Silan-Gehalts im Vergleich zur Änderung des Wasserstoff-Gehalts über das Volumen des Rohlings geringer aus als bei einer einstufigen Beladung, d.h. der Silan-Gehalt, welcher typischer Weise aufgrund des dort vorhandenen maximalen Wasserstoff-Gehalts ebenfalls im Bereich der Oberfläche maximal ist, nimmt im Volumen des Linsenelements, genauer gesagt in Dickenrichtung des Linsenelements idealer Weise auf nicht weniger als 50% bzw. 70 % bzw. 80 % des maximalen Werts ab.

Bei einer Ausführungsform fällt der Wasserstoff-Gehalt bis zu einem Abstand von 8 mm zur Oberfläche auf 40% oder weniger, bevorzugt von 30% oder weniger des Wasserstoff-Gehalts an der Oberfläche ab. Wie weiter oben dargestellt wurde, ist ein hoher Wasserstoff-Gehalt typischer Weise nur in einem an die Oberfläche unmittelbar angrenzenden Volumenbereich des Linsenelements erforderlich, so dass der Wasserstoffgehalt in einem Abstand von 8 mm zur Oberfläche bereits signifikant reduziert werden kann.

Bei einer weiteren Ausführungsform fällt der Wasserstoff-Gehalt bis zu einem Abstand von 25 mm zu der Oberfläche auf 10% oder weniger des Wasserstoff-Gehalts an der Oberfläche ab. Der Abstand von 25 mm entspricht bei einer Abschlusslinse eines Projektionsobjektivs für die Mikrolithographie in etwa dem Bereich der Mittenebene des Rohlings, aus dem das Linsenelement hergestellt wurde. In diesem Bereich ist in der Regel ein vergleichsweise geringer (minimaler) Wasserstoff-Gehalt erforderlich, da die Energiedichte dort vergleichsweise gering ist.

Bei einer weiteren Ausführungsform steigt der Gehalt an Wasserstoff in Dickenrichtung des Linsenelements von dem minimalen Wert bis zu einer weiteren Oberfläche des Linsenelements zum Durchtritt von Strahlung auf nicht mehr als 30% des Gehalts an Wasserstoff an der erstgenannten Oberfläche an. Bei einem im konvergenten oder divergenten Strahlengang angeordneten Linsenelement treten typischer Weise an den beiden mit Strahlung beaufschlagten Oberflächen unterschiedliche Strahldurchmesser auf, wobei wie oben beschrieben wurde ein besonders hoher Wasserstoff-Gehalt nur an derjenigen Oberfläche erforderlich ist, an welcher die höhere Energiedichte auftritt, d.h. es ist keine im Wesentlichen in Dickenrichtung des Linsenelements spiegelsymmetrische Wasserstoff-Verteilung erforderlich.

Um eine über die Dicke des Linsenelements asymmetrische Wasserstoff-Verteilung zu erzeugen, kann das Linsenelement beispielsweise mit einem Übermaß gefertigt werden und ein entsprechendes Stück des Rohlings, in dem ein hoher Wasserstoff-Gehalt vorhanden ist, nach der Beladung mit Wasserstoff abgetrennt werden. Auch ist es gegebenenfalls möglich, einen Rohling mit doppelter Dicke herzustellen und aus diesem zwei Linsenelemente zu fertigen, von denen eine einer hohen Energiedichte ausgesetzte Linsenfläche jeweils einer Stirnseite des Rohlings zugewandt ist, wie dies z.B. in der US 7,791,811 B2 beschrieben ist. In diesem Fall vervierfacht sich aufgrund der doppelten Dicke des Rohlings aber die Beladungsdauer des ersten Beladungsschritts.

Nicht zur Erfindung gehörig ist ein Linsenelement aus Quarzglas, an dem eine Oberfläche und eine weitere Oberfläche zum Durchtritt von Strahlung gebildet sind, wobei zumindest an einer Stelle im Volumen des Linsenelements der Gehalt an Wasserstoff einen minimalen Wert von weniger als 2 x 10¹⁵ Molekülen/cm³ aufweist, wobei der Gehalt an Wasserstoff an den Oberflächen beim 1,5-fachen bis 5-fachen des minimalen Werts liegt, und wobei der Silan-Gehalt an den Oberflächen des Linsenelements zwischen dem 1,1-fachen und dem 2,20-fachen des Silan-Gehalts an der Stelle im Volumen des Linsenelements mit dem minimalen Wert des Wasserstoff-Gehalts liegt.

Die oben beschriebenen Eigenschaften können theoretisch bei allen Arten von Linsenelementen realisiert sein, sind aber insbesondere bei Linsenelementen mit geringer Strahlungsbelastung und/oder mit geringen Unterschieden in der Energiedichte auf der Vorderseite und der Rückseite günstig. Wenn die Energiedichte gering ist, könnte rein rechnerisch ein Wasserstoffgehalt von 1 x 10¹⁵ Molekülen/cm³ oder weniger in der Mitte des Linsenelements, genauer gesagt in der Mitte des typischer Weise zylindrischen Rohlings, aus welchem das Linsenelement hergestellt wird, ausreichend sein. Aus praktischen Überlegungen wird jedoch im Stand der Technik ein höherer Mindestgehalt von ca. 5 - 10 x 10¹⁵ Molekülen/cm³ gewählt, und zwar aus folgenden Gründen:

Bei Temperaturen von 300 - 500°C und Diffusionslängen von mehreren Zentimetern bei der Beladung haben bereits geringe Temperaturschwankungen (z.B. Regeltoleranz oder lokale Schwankungen im Ofen) einen starken Einfluss auf den tatsächlichen Wasserstoffgehalt in der Mitte des Rohlings. Bei der Festlegung des Wasserstoffgehalts in der Mitte des Rohlings kann daher ein Gehalt gewählt werden, der so groß ist, dass er z.B. durch Raman-Spektroskopie nachgewiesen und ggf. korrigiert werden kann (Nachweisgrenze ca. 5 x 10¹⁵ Moleküle/cm³ bei vertretbarem Aufwand). Auch kann bewusst eine Überladung mit Wasserstoff in der Mitte des Rohlings vorgenommen werden, um einen Sicherheitsfaktor für die Temperaturschwankungen zu haben, so dass auch bei Temperaturschwankungen der erforderliche Mindestgehalt in der Mitte des Rohlings ohne Verifizierungsmessung sicher erreicht wird.

Ein weiterer Grund für die Wahl eines vergleichsweise großen Wasserstoff-Gehalts in der Mitte des Rohlings besteht darin, dass es Defekte (z.B. ODCs, stark geschwächte Bindungen) und Fremdstoffe (z.B. Sauerstoff bei Sinterung in sauerstoffhaltigem Gas) gibt, die auf der Zeitskala von Beladungen (Wochen oder Monate) quasi instantan mit Wasserstoff reagieren. Dies führt zu einer Herabsetzung der effektiven Diffusionskonstante, weil in jedem Volumenelement des Rohlings erst dann ein nennenswert von Null verschiedener Wasserstoff-Gehalt auftreten kann, wenn alle schnell absättigbaren Defekte auch abgesättigt sind. Auch aus diesem Grund ist es günstig, den Wasserstoff-Gehalt in der Mitte des Rohlings zu messen oder eine Überladung mit Wasserstoff vorzunehmen.

Die Abhängigkeit der Bildung von SiH als Funktion der Wasserstoff-Konzentration betrifft hauptsächlich gestreckte Bindungen, deren Bindungsenergie eine Verteilungsfunktion ist. Solche stabileren gestreckten Bindungen werden nur zu Silan reagieren, wenn ausreichend freier Wasserstoff und eine ausreichende Aktivierungsenergie vorhanden sind, d.h. die Reaktion läuft langsamer ab als bei der oben beschriebenen instantanen Absättigung stark reaktiver Defekte.

Beim dem hier beschriebenen Ausführungsbeispiel eines Linsenelements, bei dem die zu erwartende Energiedichte an den Oberflächen nicht zu groß ist, wird vorgeschlagen, die Dichte an reaktiven Defekten und Verunreinigungen in dem Rohling theoretisch oder experimentell zu bestimmen und einen Mittengehalt an Wasserstoff in dem Rohling festzulegen, der sich aus der maximalen Defektdichte, dem aus der Energiedichte in der Mitte des Rohlings berechneten Bedarf an Wasserstoff und einem Sicherheitsfaktor zusammensetzt und der typischerweise in der Größenordnung von ca. 0,2 bis 2 x 10¹⁵ Molekülen/cm³ liegt und der somit geringer ist als bei der herkömmlichen einstufigen Beladung.

Beim Beladen des Linsenelements bzw. des Rohlings mit Wasserstoff wird im ersten Schritt ein Partialdruck gewählt, der zu einem Gehalt am Rand des Rohlings, d.h. im Bereich der mit Strahlung zu beaufschlagenden Oberflächen, von ca. 1,5 - 5 Mal mehr als in der Mitte des Rohlings führt, d.h. der Wasserstoff-Gehalt an den Oberflächen bzw. in einem den Oberflächen unmittelbar benachbarten Volumenbereich nach diesem ersten Schritt kann beispielsweise zwischen ca. 0,3 x 10¹⁵ Molekülen/cm³ und 1,0 x 10¹⁶ Molekülen/cm³ liegen. Der Wasserstoff-Gehalt steigt hierbei von der Stelle mit dem minimalen Wasserstoff-Gehalt bis zur Oberfläche des Linsenelements typischer Weise monoton an.

Im hier beschriebenen Fall ist es günstig, wenn die Beladung mit Wasserstoff in dem ersten Schritt bei einer ausgesprochen hohen Temperatur von 700°C bis 1000°C durchgeführt wird, wobei sichergestellt sein muss, dass ein Quarzglasmaterial verwendet wird, bei dem die Grenztemperatur, bei der die thermische Bildung von Silan einsetzt, nicht überschritten wird, d.h. typischer Weise ein Quarzglasmaterial mit einem hohen OH-Gehalt von z.B. 500 ppm oder darüber. Bei diesen hohen Temperaturen fallen um z.B. 25°C abweichende Temperaturen kaum ins Gewicht, so dass der Effekt von Temperaturschwankungen bei der Beladung äußerst gering ist. Hierdurch kann insbesondere der Zielgehalt in der Mitte des Rohlings nach dem ersten Schritt nur aus der Defektdichte und einem Sicherheitsaufmaß berechnet werden. Der zweite Beladeschritt kann dem bislang bekannten einstufigen Beladeprozeß bei Temperaturen zwischen z.B. 400°C und 500°C entsprechen, wobei auf die Überladung des Rohlings in der Mitte aufgrund einer unbekannten Defektdichte verzichtet werden kann, was zu einer deutlichen Verkürzung der Dauer des Beladungsprozesses führt.

Da der in das Quarzglas-Material eindiffundierende Wasserstoff lokal noch mit Defekten reagiert, treten auch keine hohen Konzentrationen von freiem Wasserstoff auf, so dass sich in dem ersten Beladungsschritt kaum SiH aus "normalen" gestreckten Bindungen bilden kann. In dem zweiten Schritt wird der in den Randbereichen benötigte Wasserstoff bei geringerer Temperatur eingebracht, wodurch auch in dem zweiten Schritt nur ein geringer Gehalt an Silan gebildet wird. Insgesamt ergibt sich daher auch in diesem Fall eine vergleichsweise geringe Änderung der Silan-Verteilung über den Rohling (in Dickenrichtung des Linsenelements), d.h. das Verhältnis zwischen dem maximalen Silan-Gehalt, der typischer Weise am Rand des Rohlings angenommen wird, zum minimalen Silan-Gehalt (in der Regel in der axialen Mitte des Rohlings) im Volumen des Rohlings (und damit auch im Volumen des aus diesem hergestellten Linsenelements) ist kleiner als die Quadratwurzel aus dem Verhältnis zwischen dem maximalen Wasserstoff-Gehalt und dem minimalen Wasserstoff-Gehalt im Volumen des Linsenelements bzw. des Rohlings. Bei einem Verhältnis von 10 : 1 zwischen maximalem Wasserstoff-Gehalt und minimalem Wasserstoff-Gehalt liegt das Verhältnis aus maximalem und minimalem Silan-Gehalt z.B. bei weniger als 3 : 1, d.h. der Silan-Gehalt fällt im Volumen des Linsenelements typischer Weise um weniger als ca. 1 / 3, d.h. um weniger als ca. 33 %, ab.

Nicht zur Erfindung gehörig ist ein Linsenelement aus Quarzglas, bei dem das Verhältnis zwischen dem maximalen Silan-Gehalt und dem minimalen Silan-Gehalt im Volumen des Linsenelements geringer ist als die Quadratwurzel aus dem Verhältnis zwischen dem maximalen Wasserstoff-Gehalt und dem minimalen Wasserstoff-Gehalt im Volumen des Linsenelements. Ein solches Linsenelement kann insbesondere die Eigenschaften aufweisen, die im Zusammenhang mit den weiter oben beschriebenen Linsenelementen angegeben wurden.

Wie weiter oben dargestellt wurde, entspricht das Verhältnis zwischen dem maximalen und dem minimalen Silan-Gehalt im Volumen des Linsenelements im Wesentlichen dem Verhältnis aus maximalem zu minimalem Silan-Gehalt nach dem ersten Beladungsschritt (bei konstanter Temperatur). Dieses Verhältnis entspricht ungefähr der Quadratwurzel aus dem Verhältnis zwischen dem maximalen Wasserstoff-Gehalt und dem minimalen Wasserstoff-Gehalt im Volumen des Linsenelements nach dem ersten Beladeschritt. In dem zweiten Beladeschritt wird weiterer Wasserstoff in die Randbereiche des Linsenelements eingebracht, wodurch sich das Verhältnis aus maximalem Wasserstoff-Gehalt zu minimalem Wasserstoff-Gehalt nach dem zweiten Beladeschritt erhöht. Im zweiten Beladeschritt wird aber praktisch kein zusätzliches Silan mehr gebildet, so dass das Verhältnis aus maximalem zu minimalem Silan-Gehalt nach dem zweiten Beladeschritt geringer ist als die Quadratwurzel aus dem Verhältnis zwischen dem maximalen Wasserstoff-Gehalt und dem minimalen Wasserstoff-Gehalt nach dem zweiten Beladeschritt. Insbesondere kann das Verhältnis zwischen maximalem und minimalem Silan-Gehalt in dem Linsenelement um mehr als 10%, 20%, 30%, 40% oder 50% kleiner sein als die Quadratwurzel aus dem Verhältnis zwischen dem maximalen Wasserstoff-Gehalt und dem minimalen Wasserstoff-Gehalt im Volumen des Linsenelements.

In einer Ausführungsform weist das Linsenelement bei der Bestrahlung mit gepulster Laserstrahlung bei einer Wellenlänge von 193 nm eine Änderung dK / dF des Absorptionskoeffizienten K in Abhängigkeit von der Energiedichte F von weniger als 5 x 10⁻⁴ cm x Puls / mJ, bevorzugt von weniger als 1 x 10⁻⁴ cm x Puls / mJ, , besonders bevorzugt von weniger als 5 x 10⁻⁵ cm x Puls / mJ, insbesondere von weniger als 1 x 10⁻⁵ cm x Puls / mJ auf. Der Silan-Gehalt von Quarzglas kann mittels Raman-Spektroskopie nur vergleichsweise ungenau bestimmt werden: Die Nachweisgrenze liegt bei etwa 1 bis 5 x 10¹⁵ Molekülen/cm³, was für Lithographie-Anwendungen typischer Weise einen zu hohen Wert darstellt. In der weiter oben zitierten US 7,928,026 B2 (oder auch in der WO 2006/136184) wird daher ein indirektes Verfahren beschrieben, bei dem die Steigung dK / dF der Transmissionsänderung K als Funktion der Energiedichte F als Maß verwendet wird.

Die US 7,928,026 B2 wird insbesondere bezüglich des Messverfahrens, mit dem die oben beschriebenen Werte bestimmt werden können, durch Bezugnahme zum Inhalt dieser Anmeldung gemacht. Aus der US 7,928,026 B2 lässt sich entnehmen, dass die gemessenen Werte bzw. der experimentelle Messaufbau eine Reproduzierbarkeit von ungefähr 3 x 10⁻⁵ cm x Puls / mJ hat. Dies ist plausibel, da eine Messung im Bereich von Energiedichten zwischen typischer Weise 0,5 mJ/ cm² bis maximal 10 mJ/ cm² erfolgen darf (wobei bei letzterer Energiedichte bereits eine irreversible Alterung des Glases innerhalb weniger 10000 Pulse einsetzt). Eine Transmissionsmessung in einem ratiometrischen Aufbau (Strahlteiler und Referenzdetektor, Hauptdetektor hinter Probe) ist erfahrungsgemäß bestenfalls auf 0,3% genau. Mit einer 10 cm langen Probe kann somit die oben angegebene Steigung von 0,3% /10 cm / 10 mJ/cm² = 3 x 10⁻⁵ cm x Puls /mJ aufgelöst werden.

Da im Rahmen der vorliegenden Erfindung auch Beladetemperaturen unterhalb von 300°C ermöglicht werden sollen, ist die in der US 7,928,026 B2 beschriebene Auflösung zur Bestimmung des Silan-Gehalts ggf. nicht mehr ausreichend. Alternativ kann die Absorptionsänderung bzw. der Silan-Gehalt an kleinen Proben (wenige mm bis cm Pfadlänge) kalorimetrisch (vgl. die Diplomarbeit "Kalorimetrische Bestimmung der UV-Strahlungsabsorption an optischen Gläsern und dünnen Schichten unter besonderer Berücksichtigung laserinduzierter Änderungen", von Eric Eva, Laser-Laboratorium Göttingen, LLG, 1994, insbesondere Seite 34 und Seiten 36-37) oder photothermisch (vgl. K. Mann, A. Bayer, T. Miege, U. Leinhos und B. Schäfer "A Novel Photo-Thermal Setup for Evaluation of Absorptance Losses and Thermal Wavefront Deformations in DUV Optics", Proceedings of the 39th Boulder Damage Symposium, Boulder, Co (USA), SPIE Vol. 6720, 6720-72 (2007)) sowie C. Mühlig et al., "Characterization of low losses in optical thin films and materials", Applied Optics, Vol. 47, Issue 13, pp. C135-C142) vermessen werden. Diesen Verfahren ist gemeinsam, dass sie eine der als Funktion der Energiedichte veränderlichen Absorption direkt proportionale Größe wie die Erwärmung der Probe, die Verzerrung einer transmittierten Wellenfront oder die Ablenkung eines Teststrahls messen. Daher können 3-4 Größenordnungen kleinere Steigungen dK / dF gemessen werden als mittels Ratiometrie. Insbesondere die photothermischen Verfahren eignen sich auch für Linienscans an einer Probe, also zur Bestimmung des vorhergesagten Verlaufs der Absorption bzw. des Silangehalts in einem Rohling bzw. in einem Linsenelement in Dickenrichtung.

Bei einer Ausführungsform weist das Linsenelement bzw. das Quarzglas einen OH-Gehalt von weniger als 200 ppm nach Gewicht, bevorzugt von weniger als 100 ppm nach Gewicht, besonders bevorzugt von weniger als 20 ppm nach Gewicht, ganz besonders bevorzugt von weniger als 10 ppm nach Gewicht, insbesondere von weniger als 1 ppm nach Gewicht auf. Das so genannte "trockene" Quarzglas mit niedrigem OH-Gehalt eignet sich gut für die Lithographie und wird typischer Weise in einem Soot-Prozess hergestellt, gesintert und entspannungsgetempert, bevor dieses mit Wasserstoff beladen wird.

Neben einem niedrigen OH-Gehalt sollte ein Quarzglas, welches für die Mikrolithographie verwendet wird, auch eine niedrige Defektanzahl aufweisen, d.h. der Gehalt an ODC und Peroxy-Zentren sollte nicht zu groß sein, was beispielsweise durch eine kontrollierte oxidative Heilung von Defektzentren erreicht werden kann. Auch die fiktive Temperatur des Quarzglases sollte nicht zu hoch sein und z.B. bei weniger als 1000°C liegen. Bei der fiktiven Temperatur handelt es sich um einen Parameter, der die spezifische Netzwerkstruktur des Quarzglases charakterisiert und der z.B. durch IR-Spektroskopie oder durch Raman-Streuung bestimmt werden kann, wie beispielsweise in der US 7,928,026 B2 beschrieben ist.

Bei einer weiteren Ausführungsform weist das Linsenelement für Strahlung bei einer Vakuumwellenlänge von 193,368 nm (d.h. Strahlung eines ArF-Lasers) einen Brechungsindex in Vakuum von weniger als 1,560830, bevorzugt von weniger als 1,560810, besonders bevorzugt von weniger als 1,560800, insbesondere von weniger als 1,560790 auf. Eine Erhöhung des OH-Gehalts des Quarzglases um 10 ppm bewirkt einen ca. 1 ppm geringeren Brechungsindex, d.h. ein Quarzglas mit einem OH-Gehalt von ca. 200 ppm nach Gewicht weist typischer Weise den niedrigsten hier angegebenen Brechungsindex (1,560790) auf. Es versteht sich, dass der Brechungsindex des Quarzglases neben dem OH-Gehalt auch von weiteren Materialeigenschaften, beispielsweise vom Gehalt des im Quarzglas vorhandenen molekularen Wasserstoffs, beeinflusst wird.

Bei einer weiteren Ausführungsform liegt der Silan-Gehalt an allen Stellen im Volumen des Linsenelements bei weniger als 5 x 10¹⁴ Molekülen/cm³, bevorzugt bei weniger als 1 x 10¹⁴ Molekülen/cm³, insbesondere bei weniger als 5 x 10¹³ Molekülen/cm³. Unter dem Begriff Silan-Moleküle werden im Sinne dieser Anmeldung Si-H-Verbindungen verstanden. Wie weiter oben beschrieben wurde, wird der Silan-Gehalt typischer Weise indirekt über die FDT-Steigung bestimmt, da für einen direkten Nachweis die Messgrenze in der Regel zu niedrig ist. Der bei einer direkten Bestimmung ermittelte Wert für den Silan-Gehalt des Quarzglases sollte in der Regel nicht größer sein als die hier angegebenen Obergrenzen.

Es versteht sich, dass die weiter oben im Zusammenhang mit einem Linsenelement beschriebenen Eigenschaften typischer Weise auch auf einen Rohling aus Quarzglas zutreffen, aus dem ein solches Linsenelement (typischer Weise durch mechanisches Bearbeiten) hergestellt wird, d.h. auch ein typischer Weise zylinderförmiger Rohling aus Quarzglas, der auf die weiter oben im Zusammenhang mit dem Verfahren beschriebene Weise mit Wasserstoff beladen wurde, weist die oben im Zusammenhang mit dem Linsenelement beschriebenen Merkmale hinsichtlich des Wasserstoff- und des Silan-Gehalts auf.

Es hat sich in Bestrahlungsversuchen gezeigt, dass auch bei 400 - 500°C beladene trockene Sootgläser, wenn sie auf einen wegen hoher erwarteter Energiedichte hohen absoluten H₂-Gehalt beladen wurden, verstärkte Kompaktierung mit einem überlinear von der Pulszahl abhängigen Anstieg der Wellenfrontverzerrung und verfrühte Bildung von Mikrokanälen zeigen, lange bevor der Wasserstoff im Quarzglas durch die Dauerbestrahlung verbraucht ist. Im Vergleich zeigen die gleichen Quarzgläser, bei gleicher Temperatur auf 2 - 5 x geringeren H₂-Gehalt beladen, diesen Effekt nicht, solange die Gesamtdosis noch so gering ist, dass freier Wasserstoff im Quarzglas verfügbar bleibt. Dieser Effekt wird auf die eingangs erwähnte Bildung von thermischem SiH zurückgeführt, da ein Senken der Beladetemperatur auf deutlich unterhalb von 400°C bei Beibehaltung des hohen Absolutgehalts dazu führte, dass sich die Gläser genauso wie oder besser als die bei 400 - 500°C auf 2-5 x geringeren H₂-Gehalt beladenen Gläser verhielten.

Mit Hilfe des oben beschriebenen Verfahrens kann eine zeitlich praktikable Beladung im zweiten Schritt (und ggf. auch im ersten Schritt) bei Temperaturen unterhalb von 400°C, ggf. unterhalb von 300°C erfolgen, insbesondere wenn vergleichsweise kleine Rohlinge mit einer Dicke von beispielsweise weniger als ca. 8 cm, 5 cm oder 3 cm beladen werden. Auf diese Weise kann in Bereichen des Rohlings, die eine hohen Energiedichte ausgesetzt sind, ein Wasserstoff-Gehalt von mehr als 1 x 10¹⁷ Molekülen/cm³, 2 x 10¹⁷ Molekülen/cm³ oder 5 x 10¹⁷ Molekülen/cm³ erreicht werden, ohne dass die oben beschriebenen Probleme auftreten.

Bei einer Ausführungsform steigt eine Wellenfrontverzerrung des Linsenelements aufgrund von Kompaktierung bei der Bestrahlung mit gepulster Laserstrahlung bei einer Wellenlänge von 193 nm nicht mehr als linear mit der Pulszahl der gepulsten Laserstrahlung an. Wie weiter oben beschrieben wurde, kann der überlineare Anstieg der Wellenfrontverzerrung durch geringe Beladetemperaturen in den (mindestens) zwei Beladeschritten verhindert werden.

Bei einer weiteren Ausführungsform zeigt das Linsenelement nach einer Dosis von 200 Milliarden Pulsen mit einer Pulsdauer von jeweils 150 ns bei einer Energiedichte von 0,5 mJ / cm² / Puls oder nach einer Dosis von 3,5 Milliarden Pulsen mit einer Pulsdauer von jeweils 130 ns bei einer Energiedichte von 6,5 mJ / cm² / Puls keine Ausbildung von Mikrokanälen.

Eine Bestrahlung mit 200 Milliarden Pulsen und einer Energiedichte von 0,5 mJ/cm² erfolgt typischer Weise während des Betriebes des Linsenelements in einer Projektionsbelichtungsanlage über die gesamte Lebensdauer des Linsenelements, d.h. das Linsenelement bleibt über seine gesamte Lebensdauer frei von Mikrokanälen. Die Bestrahlung mit 3,5 Milliarden Pulsen bei einer höheren Energiedichte von 6,5 mJ/cm² stellt ein Testkriterium dar, welches es ermöglicht, unter Verwendung einer deutlich niedrigeren Anzahl von Pulsen zu überprüfen, ob das Linsenelement über seine gesamte Lebensdauer frei von Mikrokanälen bleiben wird.

Ein weiterer Aspekt der Erfindung betrifft eine optische Anordnung, insbesondere eine Projektionsbelichtungsanlage für die Mikrolithographie, welche mindestens ein Linsenelement wie oben beschrieben aufweist. Die Eigenschaften des für ein jeweiliges Linsenelement des Projektionsobjektivs verwendeten Quarzglases können in Abhängigkeit von der Position des Linsenelements in dem Projektionsobjektiv geeignet festgelegt werden. Beispielsweise hat die Position des Linsenelements im z.B. konvergenten oder divergenten Strahlengang einen Einfluss auf die Energiedichte der das Linsenelement durchlaufenden Strahlung und damit auf den benötigten Wasserstoff-Gehalt.

Insbesondere wenn es sich bei dem Linsenelement um ein letztes Linsenelement des Projektionsobjektivs handelt, tritt typischer Weise an der planen (ggf. an einem konischen Abschnitt des Linsenelements gebildeten) Austrittsfläche des im konvergenten Strahlengang angeordneten Linsenelements eine hohe Energiedichte auf, so dass dort ein hoher Wasserstoff-Gehalt in das Quarzglasmaterial eingebracht werden sollte. Auch bei Linsenelementen, die an anderen Stellen in dem Projektionsobjektiv oder ggf. in einem diesem im Strahlengang vorgelagerten Beleuchtungssystem angeordnet sind, kann die Wahl eines Quarzglasmaterials mit für die jeweilige Position optimierten Eigenschaften die optischen Eigenschaften der gesamten Projektionsbelichtungsanlage signifikant erhöhen. Es versteht sich, dass die hier beschriebenen Linsenelemente auch in anderen optischen Anlagen als Lithographieanlagen vorteilhaft eingesetzt werden können.

Weitere Merkmale und Vorteile der Erfindung ergeben sich aus der nachfolgenden Beschreibung von Ausführungsbeispielen der Erfindung, anhand der Figuren der Zeichnung und aus den Ansprüchen. Die einzelnen Merkmale können je einzeln für sich oder zu mehreren in beliebiger Kombination bei einer Variante der Erfindung verwirklicht sein.

### Zeichnung

Ausführungsbeispiele sind in der schematischen Zeichnung dargestellt und werden in der nachfolgenden Beschreibung erläutert. Es zeigen:
- Fig. 1: eine schematische Darstellung eines Ausführungsbeispiels einer Projektionsbelichtungsanlage für die Immersionslithographie,
- Fig. 2: eine schematische Darstellung eines letzten Linsenelements eines Projektionsobjektivs der Projektionsbelichtungsanlage von Fig. 1,
- Fig. 3: eine schematische Darstellung der in dem letzten Linsenelement auftretenden Verteilung der Energiedichte in Dickenrichtung,
- Fig. 4: eine schematische Darstellung der Verteilung des Wasserstoff-Gehalts und des Silan-Gehalts des letzten Linsenelements in Dickenrichtung,
- Fig. 5: eine Darstellung analog Fig. 4 für ein nicht zur Erfindung gehöriges letztes Linsenelement,
- Fig. 6: ein Beispiel für den Ablauf eines zweistufigen Wasserstoff-Beladeprozesses der Linsenelemente gemäß Fig. 4 und Fig. 5, und
- Fig. 7: eine Darstellung eines weiteren nicht zur Erfindung gehörigen Linsenelements für das Projektionsobjektiv von Fig. 1.

In der folgenden Beschreibung der Zeichnungen werden für gleiche bzw. funktionsgleiche Bauteile identische Bezugszeichen verwendet.

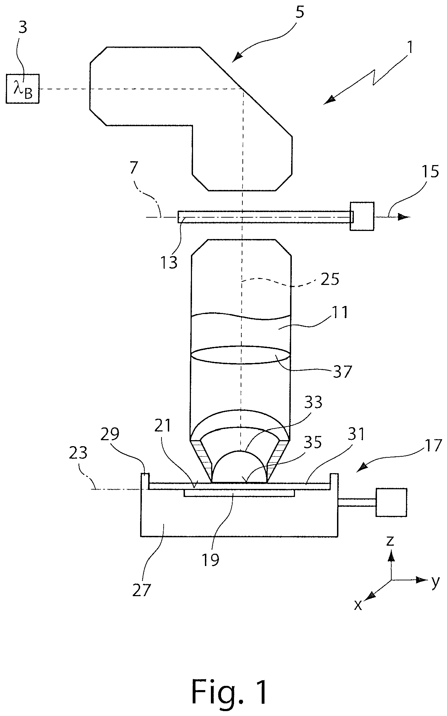

In Fig. 1 ist schematisch eine mikrolithographische Projektionsbelichtungsanlage 1 gezeigt, die zur Herstellung von hochintegrierten Halbleiterbauelementen mittels Immersionslithographie vorgesehen ist. Die Projektionsbelichtungsanlage 1 umfasst als Lichtquelle einen Excimer-Laser 3 mit einer Arbeitswellenlänge von ca. 193 nm. Alternativ könnten auch Lichtquellen anderer Arbeitswellenlängen, beispielsweise 248 nm oder 157 nm verwendet werden. Ein nachgeschaltetes Beleuchtungssystem 5 erzeugt in seiner Austrittsebene oder Objektebene 7 ein großes, scharf begrenztes, sehr homogen beleuchtetes und an die Telezentrie-Erfordernisse des nachgeschalteten Projektionsobjektivs 11 angepasstes Beleuchtungsfeld. Das Beleuchtungssystem 5 weist Einrichtungen zur Steuerung der Pupillenausleuchtung und zum Einstellen eines vorgegebenen Polarisationszustands des Beleuchtungslichts auf. Im Strahlengang hinter dem Beleuchtungssystem 5 ist eine Einrichtung (Reticle-Stage) zum Halten und Bewegen einer Maske 13 so angeordnet, dass diese in der Objektebene 7 des Projektionsobjektivs 11 liegt und in dieser Ebene zum Scanbetrieb in einer Abfahrrichtung 15 bewegbar ist.

Hinter der auch als Maskenebene bezeichneten Objektebene 7 folgt das Projektionsobjektiv 11, das ein Bild der Maske mit reduziertem Maßstab auf ein mit einem Photolack, auch Resist 21 genannt, belegtes Substrat 19, beispielsweise einen Silizium-Wafer abbildet. Das Substrat 19 ist so angeordnet, dass die ebene Substratoberfläche mit dem Resist 21 im Wesentlichen mit der Bildebene 23 des Projektionsobjektivs 11 zusammenfällt. Das Substrat wird durch eine Einrichtung 17 gehalten, die einen Antrieb umfasst, um das Substrat 19 synchron mit der Maske 13 zu bewegen. Die Einrichtung 17 umfasst auch Manipulatoren, um das Substrat 19 sowohl in z-Richtung parallel zur optischen Achse 25 des Projektionsobjektivs 11, als auch in x- und y-Richtung senkrecht zu dieser Achse zu verfahren.

Die zum Halten des Substrats 19 vorgesehene Einrichtung 17 (Wafer-Stage) ist für die Verwendung bei der Immersionslithographie konstruiert. Sie umfasst eine von einem Scannerantrieb bewegbare Aufnahmeeinrichtung 27, deren Boden eine flache Ausnehmung zur Aufnahme des Substrats 19 aufweist. Durch einen umlaufenden Rand 29 wird eine flache, nach oben offene, flüssigkeitsdichte Aufnahme für eine Immersionsflüssigkeit 31 gebildet. Die Höhe des Rands ist so bemessen, dass die eingefüllte Immersionsflüssigkeit 31 die Substratoberfläche 21 mit dem Resist vollständig bedecken und der austrittsseitige Endbereich des Projektionsobjektivs 11 bei richtig eingestelltem Arbeitsabstand zwischen Objektivaustritt und Substratoberfläche 21 in die Immersionsflüssigkeit 31 eintauchen kann. Es versteht sich, dass die Immersionsflüssigkeit 31 auch auf andere als die in Fig. 1 dargestellte Weise zwischen den Objektivaustritt und den Resist 21 eingebracht werden kann.

Das Projektionsobjektiv 11 hat eine bildseitige numerische Apertur NA von wenigstens NA = 1,2, typischer Weise von mehr als NA = 1,3, und ist damit an die Verwendung mit Immersionsflüssigkeiten besonders angepasst. Das Projektionsobjektiv 11 hat als letztes, der Bildebene 23 nächstes abbildendes optisches Element eine näherungsweise halbkugelförmige Plankonvexlinse 33, deren Austrittsfläche 35 die letzte optische Fläche des Projektionsobjektivs 11 bildet. Die Austrittsseite des letzten Linsenelements 33 ist im Betrieb der Projektionsbelichtungsanlage 1 vollständig in die Immersionsflüssigkeit 31 eingetaucht und wird von dieser benetzt. Die halbkugelförmige Plankonvexlinse 33 besteht ebenso wie eine in Fig. 1 beispielhaft dargestellte weitere Linse 37 des Projektionsobjektivs 11 aus Quarzglas.

Bei dem Quarzglas des letzten Linsenelements 33 handelt es sich um ein trockenes Quarzglas mit einem OH-Gehalt von typischer Weise weniger als 10 ppm (nach Gewicht), insbesondere von weniger als 5 ppm oder von weniger als 1 ppm (nach Gewicht), welches in einem Soot-Prozess hergestellt wurde. Das Quarzglas des letzten Linsenelements 33 ist auf eine geringe Defektdichte getempert worden, d.h. seine fiktive Temperatur T_{f} liegt unter 1000°C, sein Brechungsindex n bei einer Vakuumwellenlänge λ_{B} von 193,368 nm, welche der Wellenlänge des zur Erzeugung der Laserstrahlung 4 verwendeten Lasers 3 entspricht, liegt bei Raumtemperatur (22°C) zwischen ca. 1,560795 und 1,560830. Während die Kalibration der fiktiven Temperatur T_{f} nicht einheitlich ist, kann der Brechungsindex n, genauer gesagt dessen Realteil, sehr genau nachgewiesen werden. Bei gleichem OH-Gehalt des Quarzglases bedeutet ein kleinerer Brechungsindex n des Quarzglases einen tiefere fiktive Temperatur T_{f}.

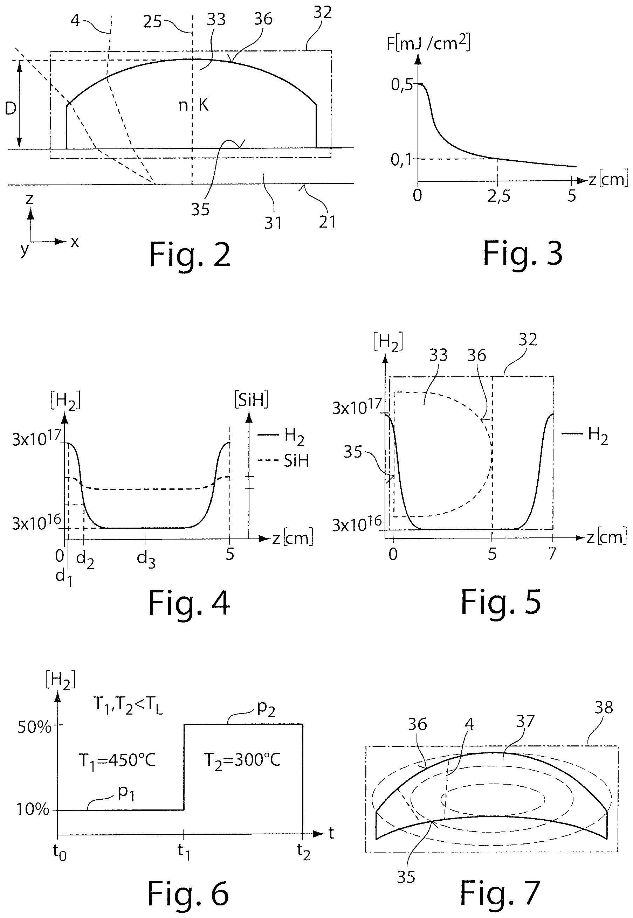

Im Betrieb der Projektionsbelichtungsanlage 1 wird das Quarzglas-Material der Linsenelemente 33, 37 von dem Excimer-Laser 3 (ArF-Laser) mit intensiven Laserpulsen bei der Betriebswellenlänge von 193 nm bestrahlt. Je nach Wahl der Beleuchtungseinstellungen (z.B. bei Dipol- oder Quadrupol-Beleuchtung) ist insbesondere das in Fig. 2 dargestellte letzte Linsenelement 33 in Teilbereichen seines Volumens, insbesondere in unmittelbarer Nähe der Austrittsfläche 35, Laserstrahlung 4 mit hohen Pulsenergiedichten von beispielsweise ca. 0,5 mJ / cm² oder darüber ausgesetzt, wobei die Pulsdauer typischer Weise bei ca. 150 ns oder darüber liegt. Unter der Pulsdauer wird - wie allgemein üblich - die äquivalente Pulsdauer bzw. das so genannte "total integral square" (TIS) verstanden, d.h. das Verhältnis aus dem Quadrat des zeitlichen Integrals über die Intensität eines Pulses zum zeitlichen Integral über die quadrierte Intensität dieses Pulses.

Wie in Fig. 3 erkennbar ist, nimmt im Volumen des letzten Linsenelements 33 in Dickenrichtung z des Linsenelements 33 die Energiedichte F ausgehend von der Lichtaustrittsfläche 35 bis zur gegenüber liegenden Lichteintrittsfläche 36 kontinuierlich ab. Am Ort der halben Dicke D / 2 = 2,5 cm des letzten Linsenelements 33 beträgt die Energiedichte F nur noch ca. 0,1 mJ / cm² / Puls, d.h. diese ist um den Faktor Fünf kleiner als an der Austrittsfläche 35. Die in Fig. 3 gezeigte Kurve zeigt für jede Position in Dickenrichtung z die maximale Energiedichte in einer dieser Position zugeordneten Ebene (d.h. in x,y-Richtung) des Linsenelements 33. Das letzte Linsenelement 33 weist im gezeigten Beispiel eine Dicke D von 5 cm auf, die Dicke eines Rohlings 32, aus dem das letzte Linsenelement 33 hergestellt wurde, ist geringfügig größer, da dieser ein (geringes) Übermaß aufweist.

Das letzte Linsenelement 33 ist für eine Belastung von ca. 200 Milliarden Pulsen mit der jeweils in Fig. 3 gezeigten Energiedichte F ausgelegt, bevor ein Austausch erforderlich wird. Um diese Lebensdauer zu erreichen, wird bei der oben beschriebenen Energiedichte F an der Austrittsfläche 35 bzw. unmittelbar benachbart zur Austrittsfläche 35, d.h. bis zu einem Abstand d₁ von 1 mm zur Austrittsfläche ein Wasserstoff-Gehalt von ca. 1 x 10¹⁷ Molekülen/cm³ benötigt, wie anhand der Verteilungskurve von Fig. 4 zu ersehen ist. Bei diesem Wert für den maximalen Wasserstoff-Gehalt handelt es sich um einen beispielhaften Wert, typische Werte für den Wasserstoff-Gehalt (oder den Deuterium-Gehalt) liegen zwischen ca. 5 x 10¹⁶ Molekülen/cm³ und 1 x 10¹⁸ Molekülen/cm³.

Typischer Weise hängt der benötigte Wasserstoff-Gehalt in einem jeweiligen Volumenbereich eines Linsenelements aus Quarzglas annähernd quadratisch von der dort auftretenden Energiedichte ab. Bei einer um einen Faktor Fünf geringeren Energiedichte F in der Mitte des letzten Linsenelements 33 wird dort demnach nur ein Wasserstoff-Gehalt von ca. 4 x 10¹⁵ Molekülen/cm³ benötigt. Aus Gründen der Prozess-Sicherheit (sicherer Nachweis durch Raman-Spektroskopie oder bei Verzicht auf Messungen nach Beladen Puffer für durch Temperaturschwankungen im Beladeofen und Schwankungen der Defektdichte im Glas hervorgerufene Konzentrationsschwankungen) wird für die Mitte des letzten Linsenelements 33 (in einem (dritten) Abstand d₃ = 2,5 cm zur (planen) Austrittsfläche 35) bzw. des zugehörigen Rohlings 32 ein Wasserstoff-Mindestgehalt von 1 x 10¹⁶ Molekülen/cm³ festgelegt. Es hat sich als günstig erwiesen, wenn der Wasserstoff-Gehalt [H₂] von der Austrittsfläche 35 vergleichsweise schnell abfällt und beispielsweise in einem zweiten Abstand d₂ = 8 mm von der Austrittsfläche 35 auf mindestens 50% des maximalen Werts des Wasserstoff-Gehalts [H₂] abfällt, der an der Austrittsfläche 35 vorliegt. Insgesamt ergibt sich somit die in Fig. 4 dargestellte, für die vorliegende Anwendung günstige Verteilung des Wasserstoff-Gehalts [H₂] in Dickenrichtung (z-Richtung) des letzten Linsenelements 33.

Um die in Fig. 4 gezeigte Verteilung des Wasserstoff-Gehalts [H₂] in dem letzten Linsenelement 33 zu erzeugen, wird eine Wasserstoff-Beladung des Rohlings 32, aus welchem das letzte Linsenelement 33 gefertigt wird, vorgenommen, welche nachfolgend anhand von Fig. 6 näher beschrieben wird.

Für die Beladung wird der Rohling 32 in einen (nicht gezeigten) Ofen eingebracht, in dem eine wasserstoffhaltige Atmosphäre herrscht und welcher bei der konventionellen Beladung auf eine konstante Temperatur aufgeheizt ist, damit der Wasserstoff aus der Umgebung in den Rohling 33 eindiffundieren kann. Die Dauer der Beladung mit Wasserstoff hängt vom gewünschten Wasserstoff-Gehalt sowie von der gewählten Temperatur bei der Beladung mit Wasserstoff ab. Typischer Weise dauert die Beladung mehrere Wochen oder Monate, wobei die Beladung bei niedrigen Temperaturen von z.B. ca. 300°C ggf. ein Jahr oder länger dauern kann.

Um die Beladedauer zu verkürzen und dennoch dafür zu sorgen, dass sich in dem Quarzglasmaterial nicht zu viel Silan (SiH) bildet, wird vorgeschlagen, den bekannten Beladeprozess wie folgt zu modifizieren: Das Beladen des Rohlings 32 erfolgt in zwei Beladungsschritten (vgl. Fig. 6), wobei in dem ersten Beladungsschritt der Rohling 32 bei einer ersten Temperatur T₁ und einem ersten Wasserstoff-Partialdruck p₁ und in dem zweiten Beladungsschritt der Rohling 32 bei einer zweiten, von der ersten verschiedenen Temperatur T₂ und einem zweiten, vom ersten verschiedenen Wasserstoff-Partialdruck p₂ beladen wird.

Typischer Weise wird hierbei der erste Beladungsschritt bei einem ersten Wasserstoff-Partialdruck p₁ vorgenommen, der kleiner ist als der zweite Wasserstoff-Partialdruck p₂ im zweiten Beladungsschritt. Auch wird die Temperatur T₁ im ersten Beladungsschritt in der Regel größer gewählt als die Temperatur T₂ im zweiten Beladungsschritt. Auf diese Weise kann beispielsweise die in Fig. 4 gezeigte Wasserstoff-Verteilung in dem Rohling 32 erzeugt werden, wie nachfolgend im Einzelnen dargestellt wird:
Im ersten Schritt wird für die Beladetemperatur T₁ ein Wert von 450°C gewählt. Bei 100% Wasserstoff-Partialdruck bei einem Gesamtdruck von 1 atm im Beladeofen stellt sich im Gleichgewichtszustand im Quarzglas eine Konzentration bzw. ein Wasserstoff-Gehalt von etwa 3 x 10¹⁷ Molekülen/cm³ ein. Demnach würde bei unendlich langer Beladung bei dieser Temperatur T₁ eine Wasserstoff-Konzentration von ca. 3% bei Normaldruck genügen, um den geforderten Wert von ca. 1 x 10¹⁶ Molekülen/cm³ in der Mitte des Rohlings 32 zu erreichen. Für Beladezeiten in der Größenordnung von einigen Wochen oder wenigen Monaten wird man im ersten Schritt einen Partialdruck p₁ von beispielsweise ca. 10% wählen. Dadurch stellt sich in den Außenbereichen des Rohlings 32, d.h. insbesondere benachbart zur späteren Austrittsfläche 35 des letzten Linsenelements 33, ein Wasserstoff-Gehalt von ca. 3 x 10¹⁶ Molekülen/cm³ ein, was bei der gewählten Temperatur T₁ von ca. 450°C im ersten Beladungsschritt noch nicht zu relevanter SiH-Bildung führt. Die erste Beladedauer t₁ - t₀ bis zum Zeitpunkt t₁ kann so kurz gewählt werden, dass sich in der Mitte des Rohlings 32 nur ca. 80 - 90% des Sollgehalts von 1 x 10¹⁶ Molekülen/cm³ einstellen, da der im ersten Beladeschritt eingebrachte Wasserstoff während des zweiten Beladungsschritts (von t₁ bis t₂) weiter nach innen diffundiert und dadurch der Sollwert in der Mitte des Rohlings 32 erreicht wird. Der erste Beladeschritt dauert in etwa so lange, wie für eine durchschnittlich oder gering belastete Linsenposition gleicher Dicke bei gleicher Beladetemperatur T₁ erforderlich ist, d.h. die Beladedauer (t₁ - t₀) des ersten Schritts liegt bei ca. 10 Wochen.

In dem zweiten Schritt wird bei deutlich geringerer Temperatur T₂, beispielhaft bei weniger als ca. 300°C, z.B. bei ca. 250°C, der in den Außenbereichen des Rohlings 32 benötigte Wasserstoff eingebracht. Im zweiten Schritt wird ein Wasserstoff-Partialdruck p₂ von 50% bezogen auf Normaldruck gewählt. Dies führt dazu, dass in den äußersten Bereichen des Rohlings 32 der Mindestgehalt von 1 x 10¹⁷ Molekülen/cm³ sicher erreicht wird. Da bei niedrigen Temperaturen die Löslichkeit von Wasserstoff höher ist, kann sich dort ggf. auch ein größerer Gehalt von annähernd 2 x 10¹⁷ Molekülen/cm³ einstellen. Wie weiter oben dargestellt wurde, darf in einem Abstand d₂ von 8 mm zur Austrittsfläche 35 der Wasserstoff-Gehalt bereits auf die Hälfte (50%) abgefallen sein, so dass bei der angegebenen Temperatur eine Beladedauer (t₂ - t₁) im zweiten Beladeschritt von wenigen Wochen ausreichend ist.

Selbstverständlich darf insbesondere für den zweiten Beladeschritt ein Druck im Beladeofen bzw. Autoklav über Normaldruck (1 atm) gewählt werden. Ebenso darf die Temperatur zwischen dem ersten und dem zweiten Schritt wieder auf Raumtemperatur (22°C) abfallen, da bei dieser keine relevante Diffusion von Wasserstoff in den Rohling 32 mehr stattfindet. Dies ermöglicht das Sammeln und Lagern von Rohlingen, die dann in einer gemeinsamen Charge dem zweiten Beladeschritt im Ofen unterworfen werden können.

Es versteht sich, dass die hier angegebenen Temperaturen T₁, T₂ und Partialdrücke p₁, p₂ nur beispielhaft zu verstehen sind. Typischer Weise werden die Partialdrücke p₁, p₂ so aufeinander abgestimmt, dass sich in wirtschaftlich vertretbarer Gesamtprozessdauer (t₀ bis t₂) in der Mitte des Rohlings 32 der gewünschte Wasserstoff-Gehalt einstellt. Je nach Anwendung kann der erste Partialdruck p₁ beispielsweise bei ca. 20% oder weniger liegen und der zweite Partialdruck p₂ bei ca. 50% oder darüber, ggf. bei 90% oder darüber, insbesondere auch bei 100% oder darüber (wenn in dem Ofen ein Druck über Normaldruck, d.h. von mehr als 1 atm herrscht). Insbesondere kann die erste Temperatur T₁ zwischen ca. 400°C und 500°C liegen, es sind aber auch Temperaturen möglich, die deutlich höher liegen, wie weiter unten näher beschrieben wird. Die zweite Temperatur T₂ liegt typischer Weise bei 400°C oder darunter, kann aber insbesondere auch bei 300°C oder darunter liegen.

Um die Beladetemperatur T₁ in dem ersten Schritt festzulegen, kann wie folgt vorgegangen werden: Zunächst wird für ein Grundglas (vor der Beladung) ein der späteren Anwendung angemessener Wasserstoff-Gehalt gewählt, der von der maximal erwarteten Energiedichte und Pulszahl auf dem jeweiligen Linsenelement im optischen System bestimmt wird. Dann werden bei verschiedenen Temperaturen beladene Proben bzw. Rohlinge hergestellt, einem FDT-Test unterworfen, beispielsweise wie dies in der US 7928026 B2 dargestellt ist, und eine Grenztemperatur T_{L} gefunden, ab welcher der FDT-Wert, d.h. die Steigung dK / dF des Absorptionskoeffizienten K (vgl. Fig. 2) deutlich ansteigt (für die Gläser aus Fig. 2 der US 7928026 B2 beispielsweise T_{L} von ca. 475°C). Insbesondere kann die Grenztemperatur T_{L} auch durch einen Vergleich der Steigung dK / dF mit einem Schwellwert bestimmt werden, der beispielsweise bei 5 x 10⁻⁴ cm x Puls / mJ oder darunter liegen kann. Für die tatsächliche Beladung in der Serienfertigung wird eine geringere Temperatur T₁ mit ausreichendem Abstand zu dem Punkt, ab dem die Steigung deutlich zunimmt (d.h. zur Grenztemperatur T_{L}) festgelegt. Es versteht sich, dass auch die Beladetemperatur T₂ im zweiten Schritt geringer gewählt wird als die Grenztemperatur T_{L}.

Da die FDT-Steigung nur ein notwendiger Indikator für gutes Lebensdauerverhalten ist, kann das Quarzglasmaterial zur vollständigen Qualifizierung noch einem Langzeittest unterworfen werden, bei dem es für mehrere Mrd. Pulse mit Energiedichten bis zu ca. einer Größenordnung über den späteren Einsatzbedingungen bestrahlt und danach auf Compaction, induzierte Absorption, Wasserstoff-Verbrauch etc. untersucht wird. Es ist auch möglich, für verschieden hoch belastete Linsenpositionen, die einen unterschiedlichen Wasserstoff-Gehalt und unterschiedliche Laserfestigkeit benötigen, bei gleichem Grundglas unterschiedliche Beladetemperaturen zu wählen.

Bei gegebener (erster) Beladetemperatur T₁ ist jetzt noch zu klären, wie die SiH-Konzentration von der Wasserstoff-Konzentration abhängt. Allgemein wird auch die Art der Vorgängerdefekte des Grundglases diesen Zusammenhang beeinflussen, anhand von Tabelle 1 der US 7,928,026 B2 lassen sich jedoch Anhaltspunkte für diesen Zusammenhang ableiten: Für Paare von Rohlingen mit gleicher Beladetemperatur und annähernd gleichem OH-Gehalt sowie gleicher fiktiver Temperatur verhält sich die FDT-Steigung (dK/dF) überwiegend wie die Quadratwurzel der Wasserstoff-Gehalte. Legt man diese Beziehung zu Grunde, würde sich bei konventioneller Beladung mit konstanter Temperatur bei der in Fig. 4 gezeigten Wasserstoff-Verteilung in den Außenbereichen des Rohlings 32 ein hoher Silan-Gehalt einstellen, und zwar bei dem in Fig. 4 dargestellten Verhältnis von 10:1 beim Wasserstoff-Gehalt [H₂] von der Austrittsfläche 35 zur Mitte des Rohlings 32 typischer Weise ein Verhältnis von 3,1:1 im Silan-Gehalt.

Beim dem weiter oben vorgeschlagenen zweistufigen Verfahren ergibt sich nur eine geringe Erhöhung des Silangehalts in den Außenbereichen des Rohlings, der im Bereich der Austrittsfläche 35 in der Größenordnung einiger 10% liegt, wie in Fig. 4 ebenfalls zu erkennen ist, welche den Silan-Gehalt [SiH] (in beliebigen Einheiten) zeigt und der typischer Weise in einer Größenordnung zwischen ca. 1 x 10¹³ Molekülen/cm³ und 5 x 10¹⁵ Molekülen/cm³ liegt, wobei idealer Weise an allen Stellen im Volumen des Linsenelements bzw. des Rohlings 32 der Silan-Gehalt bei weniger als 5 x 10¹⁴ Molekülen/cm³, bei weniger als 1 x 10¹⁴ Molekülen/cm³, oder bei weniger als 5 x 10¹³ Molekülen/cm³ liegt. Der Silan-Gehalt variiert somit über das Volumen des Rohlings 32 (in Dickenrichtung z) um weniger als 30%, d.h. der (minimale) Wert in der Mitte des Rohlings 32 liegt um weniger als 30% unter dem maximalen Wert des Silan-Gehalts, der am Rand des Rohlings 32 im Bereich der späteren Austrittsfläche 35 auftritt.

Da die herkömmlicher Weise für die Bestimmung des Silan-Gehalts verwendete Raman-Spektroskopie für Lithographie-Anwendungen in der Regel eine zu hohe Nachweisgrenze aufweist, kann als Maß für den Silan-Gehalt die FDT-Steigung herangezogen werden, welche als die Änderung dK / dF des Absorptionskoeffizienten K des Quarzglases in Abhängigkeit von der Energiedichte F bei der Bestrahlung mit gepulster Laserstrahlung bei der hier verwendeten Betriebs-Wellenlänge λ_{B} = ca. 193 nm definiert ist. Im oben dargestellten Fall ergibt sich eine FDT-Steigung (dK / dF) von weniger als 5 x 10⁻⁴ cm x Puls / mJ, von weniger als 1 x 10⁻⁴ cm x Puls / mJ, von weniger als 5 x 10⁻⁵ cm x Puls / mJ, im Idealfall von weniger als 1 x 10⁻⁵ cm x Puls / mJ bei einer geringen und damit wirtschaftlichen Beladedauer.

Insgesamt lässt sich durch das hier beschriebene Beladeverfahren ein auf das Anforderungsprofil des letzten Linsenelements 33 maßgeschneiderter Verlauf des Wasserstoff-Gehalts erhalten, der bei einer herkömmlichen Beladung mit einheitlicher Beladetemperatur nicht möglich gewesen wäre: Der hohe Wasserstoff-Gehalt ist sehr eng auf die äußeren Millimeter des Linsenelements 33 bzw. des Rohlings 32 beschränkt und weist nicht die starke Überhöhung auf, die sich bei Beladung mit mehr als Normaldruck ergibt. Der vom Wasserstoff-Gehalt abhängige Brechzahlverlauf im Linsenelement 33 ist flacher und reproduzierbarer und dieses daher einfacher handhabbar. Durch die Beladung der Außenbereiche bei geringerer Temperatur T₂ ist der Silan-Gehalt nur unwesentlich erhöht, wodurch eine bessere Performance über die Lebensdauer und eine höhere Beladung entsprechend der vollen angestrebten Lebensdauer möglich ist. Im Inneren des letzten Linsenelements 33 liegt die in Fig. 4 gezeigte Ist-Kurve des Wasserstoff-Gehalts [H₂] nur knapp über der (nicht dargestellten) Bedarfskurve, wodurch sich bei der Integration entlang des Strahlweges durch das Linsenelement 33 weniger Absorption und weniger Absorptionsänderung als Funktion der Energiedichte ergibt.

Sofern sich der gespiegelte Verlauf des Wasserstoff-Gehalts [H₂] auf der anderen Seite des Rohlings 32 bzw. an der Lichteintrittsfläche 36 des letzten Linsenelements 32 als störend erweisen sollte, kann der Rohling 32 wie in Fig. 5 dargestellt beispielsweise mit einem Übermaß von z.B. 1 bis 2 cm Dicke hergestellt werden und dieses Übermaß nach Beladung abgetrennt werden, wie in Fig. 5 angedeutet ist. Wie anhand von Fig. 5 erkennbar ist, steigt der Wasserstoff-Gehalt [H₂] in Dickenrichtung (z-Richtung) von dem minimalen Wert, der in der Mitte des Rohlings 32 angenommen wird, durch das Abtrennen des Übermaßes bis zur Lichteintrittsfläche 36 nur noch unwesentlich an und erreicht dort nicht mehr als 30% des Gehalts an Wasserstoff an der Lichtaustrittsfläche 35, d.h. es kann auf diese Weise eine nicht spiegelsymmetrische Wasserstoff-Verteilung in dem letzten Linsenelement 33 erzeugt werden.

Das oben beschriebene Verfahren zur Beladung eines Rohlings mit Wasserstoff lässt sich nicht nur bei Linsenelementen anwenden, die mit Strahlung einer hohen Energiedichte beaufschlagt werden und demzufolge mit einem hohen Wasserstoff-Gehalt beladen werden müssen, vielmehr kann das oben beschriebene Verfahren zum Beladen von beliebigen Linsenelementen vorteilhaft angewendet werden, insbesondere bei Linsenelementen mit geringer Belastung und/oder geringem Unterschied in der Energiedichte auf Vorder- und Rückseite, wie nachfolgend beispielhaft anhand des in Fig. 7 dargestellten konkav-konvexen Meniskus-Linsenelements 37 dargestellt wird. Wie in Fig. 7 angedeutet ist, ist das Meniskus-Linsenelement 37 im konvergenten Strahlengang der Laserstrahlung 4 angeordnet, d.h. die konvex gekrümmte Linsenfläche 36 stellt die Lichteintrittsfläche und die konkav gekrümmte Linsenfläche 35 stellt die Lichtaustrittsfläche dar, wobei wie oben beschrieben die Unterschiede in den Energiedichten an den beiden Oberflächen 35, 36 vergleichsweise gering sind.

Im vorliegenden Ausführungsbeispiel wird vorgeschlagen, die Dichte an reaktiven Defekten und Verunreinigungen des Grundglases (d.h. des Glases vor der Beladung) theoretisch oder experimentell zu bestimmen und einen Mittengehalt in einem Rohling 38 festzulegen, der sich aus der maximalen Defektdichte, dem aus der Energiedichte in der Mitte berechneten Bedarf und einem Sicherheitsfaktor zusammensetzt und typischerweise in der Größenordnung von 0,2 bis 2 x 10¹⁵ Molekülen/cm³ liegt, d.h. niedriger ist als der üblicher Weise in der Mitte des Rohlings 38 eingestellte Wasserstoff-Gehalt, der bei ca. 5 bis 10 x 10¹⁵ Molekülen/cm³ liegt.

Im ersten Schritt der Beladung des Rohlings 38 wird ein Partialdruck p₁ von typischer Weise zwischen 0,25 % und 2,5 % gewählt, der bei geeignet gewählter erster Beladungsdauer t₁ - t₀ von mehreren Wochen bis Monaten zu einem Wasserstoff-Gehalt am Rand des Rohlings 38 führt, der 1,5 x bis 5 x über dem Wasserstoff-Gehalt in der Mitte des Rohlings 38 liegt, d.h. typischer Weise bis zu einem Abstand von 1 mm zur jeweiligen Oberfläche 35, 36 des Meniskus-Linsenelements 37 zu einem Wasserstoff-Gehalt zwischen ca. 0,3 x 10¹⁵ Molekülen / cm³ und 1 x 10¹⁶ Molekülen / cm³ führt.

Der erste Schritt der Beladung wird in diesem Beispiel bei ausgesprochen hoher Temperatur T₁ von in der Regel zwischen ca. 500°C und 1000°C, bevorzugt zwischen 700°C und 1000°C durchgeführt, wobei darauf zu achten ist, dass ein Quarzglasmaterial verwendet wird, welches eine Grenztemperatur T_{L} aufweist, die oberhalb der ersten Temperatur T₁ liegt. Bei derart hohen Temperaturen fallen um z.B. 25°C abweichende Temperaturen während der Beladung kaum ins Gewicht. Da der in das Quarzglasmaterial diffundierende Wasserstoff lokal noch mit dort vorhanden Defekten reagiert, treten keine hohen Konzentrationen von freiem Wasserstoff auf, so dass sich auch kein zu hoher Silan-Gehalt in dem Quarzglas-Rohling 38 einstellt.

In dem zweiten Schritt der Beladung wird der in den Randbereichen bzw. an den Oberflächen 35, 36 benötigte erhöhte Wasserstoff-Gehalt bei geringerer Temperatur T₂, beispielsweise zwischen 400°C und 500°C, und höherem Partialdruck p₂ zwischen ca. 1 % und 20 % eingebracht, wobei die Dauer t₂ - t₁ des zweiten Beladeschrittes bei beispielsweise ca. sechs Wochen liegt. Neben dem geringen Gesamtgehalt an Silan, der auch in diesem Beispiel über die FDT-Steigung dK / dF nachgewiesen bei weniger als 5 x 10⁻⁴ cm x Puls / mJ liegt, liegt aufgrund der zweistufigen Beladung der Silan-Gehalt an den Oberflächen 35, 36 bzw. an den Außenseiten des Rohlings 38 zwischen dem 1,1-fachen und dem 2,20-fachen des Silan-Gehalts in der Mitte des Rohlings 38. Das Verhältnis aus maximalem zu minimalem Silan-Gehalt ist somit geringer als die Quadratwurzel aus dem Verhältnis zwischen dem maximalen Wasserstoff-Gehalt und dem minimalen Wasserstoff-Gehalt im Volumen des Rohlings 38.

In der hier beschriebenen Variante des Verfahrens wird der Zielgehalt in der Mitte des Rohlings 38 nach dem ersten Schritt nur aus der Defektdichte und einem Sicherheitsaufmaß berechnet. Der zweite Beladeschritt entspricht dem bislang bekannten einstufigen Beladeprozess bei T₂ = 400 - 500°C, jedoch kann auf die Überladung in der Mitte des Rohlings 38 wegen unbekannter Defektdichte verzichtet werden, was den Beladeprozess insgesamt deutlich verkürzt. Dies ist insbesondere günstig, wenn die Dicke des Rohlings 36, 38 vergleichsweise groß ist und z.B. bei mehr als ca. 5 cm liegt, da in diesem Fall bei einem herkömmlichen Beladeverfahren mit konstanter Temperatur von z.B. 300°C Beladedauern von mehr als einem Jahr resultieren können.

Es versteht sich, dass während eines Beladungsschritts mit konstanter Temperatur T₁ bzw. T₂ gegebenenfalls der Wasserstoff-Partialdruck p₁, p₂ über die Zeit variiert werden kann, wie dies in der eingangs zitierten US 6810687 B2 oder der US799408 B2 dargestellt ist. Insbesondere im zweiten Schritt kann auch in dem Ofen ein Gesamtdruck von mehr als 1 atm eingestellt werden. Wie anhand von Fig. 7 ebenfalls zu erkennen ist, stellt sich in dem Rohling 38 eine dreidimensionale Verteilung des Wasserstoff-Gehalts ein, bei der Flächen gleicher Wasserstoff-Konzentration Rotationsellipsoide bilden, wobei in der Mitte des zylindrischen Rohlings 38 sich ein minimaler Wasserstoff-Gehalt einstellt. Im gezeigten Fall ist die konkave Linsenfläche 35 von der Stirnseite des Rohlings 38 vergleichsweise weit beabstandet, so dass dort der Wasserstoff-Gehalt ggf. deutlich geringer ist als an der Stirnseite des Rohlings 38. Bei einem solchen Meniskus-Linsenelement 37 kann es daher günstig sein, vor dem Beladen mit Wasserstoff mechanisch vorzubearbeiten, um die Geometrie des Rohlings 38 an die spätere Linsengeometrie anzupassen, wie dies beispielsweise in der DE 10 2007 022 881 A1 beschrieben ist, welche durch Bezugnahme zum Inhalt dieser Anmeldung gemacht wird.

Mit Hilfe des oben beschriebenen Verfahrens kann eine zeitlich praktikable Beladung im zweiten Schritt und ggf. auch im ersten Schritt bei Temperaturen unterhalb von 400°C oder unterhalb von 300°C insbesondere bei vergleichsweise kleinen Rohlingen erfolgen. Auf diese Weise kann sichergestellt werden, dass eine Wellenfrontverzerrung der Linsenelemente 33, 37 aufgrund von Kompaktierung bei der Bestrahlung mit gepulster Laserstrahlung bei einer Wellenlänge von 193 nm nicht mehr als linear mit der Pulszahl der gepulsten Laserstrahlung ansteigt bzw. dass sich an den Linsenelementen 33, 37 auch nach der Bestrahlung mit ca. 200 Milliarden Pulsen bei Energiedichten von 0,5 mJ / Puls, d.h. über ihre gesamte Lebensdauer, keine Mikrokanäle ausbilden.

## Patentansprüche

1. Verfahren zum Beladen eines Rohlings (32, 38) aus Quarzglas mit Wasserstoff,
wobei das Beladen zwei Schritte umfasst, wobei in dem ersten Schritt der Rohling (32, 38) bei einer ersten Temperatur (T₁) und einem ersten Wasserstoff-Partialdruck (p₁) und in dem zweiten Schritt bei einer zweiten, von der ersten verschiedenen Temperatur (T₂) und einem zweiten, vom ersten verschiedenen Wasserstoff-Partialdruck (p₂) beladen wird, wobei die erste und zweite Temperatur (T₁, T₂) kleiner als eine Grenztemperatur (T_{L}) sind, bei der eine thermische Bildung von Silan in dem Quarzglas des Rohlings (32, 38) einsetzt, und wobei in dem zweiten Schritt der Rohling (32, 38) bei einer geringeren Temperatur (T₂ < T₁) beladen wird als in dem ersten Schritt.

2. Verfahren nach Anspruch 1, bei dem der Rohling (32, 38) in dem zweiten Schritt bei einem höheren Wasserstoff-Partialdruck (p₂ > p₁) beladen wird als in dem ersten Schritt.

3. Verfahren nach einem der vorhergehenden Ansprüche, bei dem in einem dem Beladen vorausgehenden Schritt die Grenztemperatur (T_{L}) bestimmt wird, bei der die thermische Bildung von Silan in dem Quarzglas des Rohlings (32, 38) einsetzt.

4. Verfahren nach Anspruch 3, bei dem die Grenztemperatur (T_{L}) anhand einer Änderung (dK / dF) des Absorptionskoeffizienten (K) des Quarzglases des Rohlings (34, 38) in Abhängigkeit von der Energiedichte (F) bei der Bestrahlung des Rohlings (34, 38) mit gepulster Laserstrahlung bei einer Wellenlänge von 193 nm bestimmt wird.

5. Verfahren nach einem der vorhergehenden Ansprüche, bei dem der Rohling (32, 38) in dem ersten Schritt bei einer Temperatur (T₁) von weniger als 475°C, bevorzugt von weniger als 450°C beladen wird.

6. Verfahren nach einem der vorhergehenden Ansprüche, bei dem der Rohling (32, 38) in dem zweiten Schritt bei einer Temperatur (T₂) von weniger als 400°C, bevorzugt von weniger als 300°C beladen wird.

7. Verfahren nach einem der vorhergehenden Ansprüche, bei dem der Rohling (32, 38) in dem ersten Schritt bei einem Wasserstoff-Partialdruck (p₁) von weniger als 20%, bevorzugt von weniger als 10% beladen wird.

8. Verfahren nach einem der vorhergehenden Ansprüche, bei dem der Rohling (32, 38) in dem zweiten Schritt bei einem Wasserstoff-Partialdruck (p₂) von 50% oder mehr, bevorzugt von 90% oder mehr, besonders bevorzugt von 100% oder mehr beladen wird.

9. Linsenelement (33) aus Quarzglas, an dem eine Oberfläche (35) und eine weitere Oberfläche (36) zum Durchtritt von Strahlung gebildet sind,
wobei das Linsenelement (33) bis zu einem Abstand (d₁) von 1 mm zur Oberfläche (35) einen Wasserstoff-Gehalt ([H₂]) von mindestens 5 x 10¹⁶ Molekülen / cm³, bevorzugt von mindestens 5 x 10¹⁷ Molekülen / cm³, insbesondere von mindestens 10 x 10¹⁷ Molekülen / cm³ aufweist, wobei im Volumen des Linsenelements (33) der Wasserstoff-Gehalt ([H₂]) auf einen minimalen Wert von 10% oder weniger des Wasserstoff-Gehalts ([H₂]) an der Oberfläche (35) abfällt, wobei der Wasserstoff-Gehalt ([H₂]) bis zu einem Abstand (d₂) von 8 mm zu der Oberfläche (35) auf 50% oder weniger des Wasserstoff-Gehalts ([H₂]) an der Oberfläche (35) abfällt, und wobei an allen Stellen im Volumen des Linsenelements (33, 37) der Silan-Gehalt bei weniger als 5 x 10¹⁴ Molekülen/cm³ liegt.

10. Linsenelement nach Anspruch 9, bei welchem der Silan-Gehalt über die Dicke (D) des Linsenelements (33) um nicht mehr als 50%, bevorzugt um nicht mehr als 30%, insbesondere um nicht mehr als 20% variiert.

11. Linsenelement nach Anspruch 9 oder 10, bei dem der Wasserstoff-Gehalt ([H₂]) bis zu dem Abstand (d₂) von 8 mm zu der Oberfläche (35) auf 40% oder weniger des Wasserstoff-Gehalts ([H₂]) an der Oberfläche (35) abfällt.

12. Linsenelement nach einem der Ansprüche 9 bis 11, bei dem der Wasserstoff-Gehalt ([H₂]) bis zu einem Abstand (d₃) von 25 mm zu der Oberfläche (35) auf 10% oder weniger des Wasserstoff-Gehalts ([H₂]) an der Oberfläche (35) abfällt.

13. Linsenelement nach einem der Ansprüche 9 bis 12, bei dem der Wasserstoff-Gehalt ([H₂]) in Dickenrichtung (z) des Linsenelements (33) von dem minimalen Wert bis zu der weiteren Oberfläche (36) zum Durchtritt von Strahlung auf nicht mehr als 30% des Wasserstoff-Gehalts ([H₂]) an der Oberfläche (35) ansteigt.

14. Linsenelement nach einem der Ansprüche 9 bis 13, welches bei Bestrahlung mit gepulster Laserstrahlung bei einer Wellenlänge von 193 nm eine Änderung dK / dF des Absorptionskoeffizienten K in Abhängigkeit von der Energiedichte F von weniger als 5 x 10⁻⁴ cm x Puls / mJ, bevorzugt von weniger als 1 x 10⁻⁴ cm x Puls / mJ, besonders bevorzugt von weniger als 5 x 10⁻⁵ cm x Puls / mJ, insbesondere von weniger als 1 x 10⁻⁵ cm x Puls / mJ aufweist.

15. Linsenelement nach einem der Ansprüche 9 bis 14, welches einen OH-Gehalt von weniger als 200 ppm nach Gewicht, bevorzugt von weniger als 100 ppm nach Gewicht, besonders bevorzugt von weniger als 20 ppm nach Gewicht, ganz besonders bevorzugt von weniger als 10 ppm nach Gewicht, insbesondere von weniger als 10 ppm nach Gewicht, aufweist.

16. Linsenelement nach einem der Ansprüche 9 bis 15, welches für Strahlung bei einer Wellenlänge (λ_{B}) von 193,368 nm einen Brechungsindex (n) von weniger als 1,560830, bevorzugt von weniger als 1,560810, besonders bevorzugt von weniger als 1,560800, insbesondere von weniger als 1,560790 aufweist.

17. Linsenelement nach einem der Ansprüche 9 bis 16, bei dem an allen Stellen im Volumen des Linsenelements (33, 37) der Silan-Gehalt bei weniger als 1 x 10¹⁴ Molekülen/cm³, insbesondere bei weniger als 5 x 10¹³ Molekülen/cm³ liegt.

18. Linsenelement nach einem der Ansprüche 9 bis 17, dessen Wellenfrontverzerrung aufgrund von Kompaktierung bei der Bestrahlung mit gepulster Laserstrahlung bei einer Wellenlänge von 193 nm nicht mehr als linear mit der Pulszahl ansteigt.

19. Linsenelement nach einem der Ansprüche 9 bis 18, das nach einer Dosis von 200 Milliarden Pulsen mit einer Pulsdauer von jeweils 150 ns bei einer Energiedichte von 0,5 mJ / cm² / Puls oder bei einer Dosis von 3,5 Milliarden Pulsen mit einer Pulsdauer von jeweils 130 ns bei einer Energiedichte von 6,5 mJ / cm² / Puls keine Ausbildung von Mikrokanälen zeigt.

20. Projektionsobjektiv (11), insbesondere für die Immersionslithographie, umfassend mindestens ein Linsenelement (33, 37) nach einem der Ansprüche 9 bis 19.

21. Projektionsobjektiv nach Anspruch 20, bei dem das Linsenelement ein letztes Linsenelement (33) des Projektionsobjektivs (11) ist.

## Claims

1. Process for loading a blank (32, 38) composed of fused silica with hydrogen,
wherein the loading comprises two steps, wherein the blank (32, 38) is loaded at a first temperature (T₁) and a first hydrogen partial pressure (p₁) in the first step and is loaded at a second temperature (T₂) which is different from the first temperature and a second hydrogen partial pressure (p₂) which is different from the first hydrogen partial pressure in the second step, wherein the first and second temperatures (T₁, T₂) are lower than a limit temperature (T_{L}) at which thermal formation of silane in the fused silica of the blank (32, 38) commences and wherein the blank (32, 38) is loaded in the second step at a lower temperature (T₂ < T₁) than in the first step.

2. Process according to Claim 1, wherein the blank (32, 38) is loaded in the second step at a higher hydrogen partial pressure (p₂ > p₁) than in the first step.

3. Process according to either of the preceding claims, wherein the limit temperature (T_{L}) at which the thermal formation of silane in the fused silica of the blank (32, 38) commences is determined in a step preceding loading.

4. Process according to Claim 3, wherein the limit temperature (T_{L}) is determined by means of a change (dK/dF) of the absorption coefficient (K) of the fused silica of the blank (34, 38) as a function of the energy density (F) in the irradiation of the blank (34, 38) with pulsed laser radiation at a wavelength of 193 nm.

5. Process according to any of the preceding claims, wherein the blank (32, 28) is loaded in the first step at a temperature (T₁) of less than 475°C, preferably less than 450°C.

6. Process according to any of the preceding claims, wherein the blank (32, 38) is loaded in the second step at a temperature (T₂) of less than 400°C, preferably less than 300°C.

7. Process according to any of the preceding claims, wherein the blank (32, 38) is loaded in the first step at a hydrogen partial pressure (p₁) of less than 20%, preferably less than 10%.

8. Process according to any of the preceding claims, wherein the blank (32, 38) is loaded in the second step at a hydrogen partial pressure (p₂) of 50% or more, preferably 90% or more, particularly preferably 100% or more.

9. Lens element (33) composed of fused silica on which a surface (35) and a further surface (36) for passage of radiation are formed, wherein the lens element (33) has a hydrogen content ([H₂]) of at least 5 × 10¹⁶ molecules/cm³, preferably at least 5 × 10¹⁷ molecules/cm³, in particular at least 10 × 10¹⁷ molecules/cm³, up to a distance (d₁) of 1 mm from the surface (35), wherein the hydrogen content ([H₂]) decreases in the volume of the lens element (33) to a minimum value of 10% or less of the hydrogen content ([H₂]) at the surface (35), wherein the hydrogen content ([H₂]) decreases to 50% or less of the hydrogen content ([H₂]) at the surface (35) up to a distance (d₂) of 8 mm from the surface (35) and wherein the silane content is less than 5 × 10¹⁴ molecules/cm³, at all points in the volume of the lens element (33, 37).

10. Lens element according to Claim 9, wherein the silane content varies by not more than 50%, preferably by not more than 30%, in particular by not more than 20%, over the thickness (D) of the lens element (33) .

11. Lens element according to Claim 9 or 10, wherein the hydrogen content ([H₂]) decreases to 40% or less of the hydrogen content ([H₂]) at the surface (35) up to the distance (d₂) of 8 mm from the surface (35) .

12. Lens element according to any of Claims 9 to 11, wherein the hydrogen content ([H₂]) decreases to 10% or less of the hydrogen content ([H₂]) at the surface (35) up to a distance (d₃) of 25 mm from the surface (35) .

13. Lens element according to any of Claims 9 to 12, wherein the hydrogen content ([H₂]) increases in the thickness direction (z) of the lens element (33) from the minimum value to not more than 30% of the hydrogen content ([H₂]) at the surface (35) up to the further surface (36) for passage of radiation.

14. Lens element according to any of Claims 9 to 13 which on irradiation with pulsed laser radiation at a wavelength of 193 nm displays a change dK/dF in the absorption coefficient K as a function of the energy density F of less than 5 × 10⁻⁴ cm × pulse/mJ, preferably less than 1 × 10⁻⁴ cm × pulse/mJ, particularly preferably less than 5 × 10⁻⁵ cm × pulse/mJ, in particular less than 1 × 10⁻⁵ cm × pulse/mJ.

15. Lens element according to any of Claims 9 to 14 which has an OH content of less than 200 ppm by weight, preferably less than 100 ppm by weight, particularly preferably less than 20 ppm by weight, very particularly preferably less than 10 ppm by weight, in particular less than 10 ppm by weight.

16. Lens element according to any of Claims 9 to 15 which has an index of refraction (n) of less than 1.560830, preferably less than 1.560810, particularly preferably less than 1.560800, in particular less than 1.560790, for radiation at a wavelength (λ_{B}) of 193.368 nm.

17. Lens element according to any of Claims 9 to 16, wherein the silane content is less than 1 × 10¹⁴ molecules/cm³, in particular less than 5 × 10¹³ molecules/cm³, at all points in the volume of the lens element (33, 37).

18. Lens element according to any of Claims 9 to 17 which due to compaction irradiation with pulsed laser radiation at a wavelength of 193 nm displays a wave front distortion which increases not more than linearly with the number of pulses.

19. Lens element according to any of Claims 9 to 18 which after a dosage of 200 thousand million pulses having a pulsed duration of in each case 150 ns at an energy density of 0.5 mJ/cm²/pulse or a dosage of 3.5 thousand million pulses having a pulsed duration of in each case 130 ns at an energy density of 6.5 mJ/cm²/pulse does not display any formation of microchannels.

20. Projection lens (11), in particular for immersion lithography, comprising at least one lens element (33, 37) according to any of Claims 9 to 19.

21. Projection lens according to Claim 20, wherein the lens element is a last lens element (33) of the projection lens (11).

## Revendications

1. Procédé de chargement d'une ébauche (32, 38) en verre de quartz avec de l'hydrogène,
le chargement comprenant deux étapes, l'ébauche (32, 38) étant chargée lors de la première étape à une première température (T₁) et une première pression partielle d'hydrogène (p₁) et lors de la deuxième étape à une deuxième température (T₂) différente de la première et à une deuxième pression partielle d'hydrogène (p₂) différente de la première, la première et la deuxième température (T₁, T₂) étant inférieures à une température limite (T_{L}) à laquelle une formation thermique de silane dans le verre de quartz de l'ébauche (32, 38) débute, et l'ébauche (32, 38) étant chargée lors de la deuxième étape à une température plus basse (T₂ < T₁) que lors de la première étape.

2. Procédé selon la revendication 1, selon lequel l'ébauche (32, 38) est chargée lors de la deuxième étape à une pression partielle d'hydrogène plus élevée (p₂ > p₁) que lors de la première étape.

3. Procédé selon l'une quelconque des revendications précédentes, selon lequel la température limite (T_{L}) à laquelle la formation thermique de silane dans le verre de quartz de l'ébauche (32, 38) débute est déterminée lors d'une étape précédant le chargement.

4. Procédé selon la revendication 3, selon lequel la température limite (T_{L}) est déterminée à partir d'une modification (dK/dF) du coefficient d'absorption (K) du verre de quartz de l'ébauche (34, 38) en fonction de la densité énergétique (F) lors de l'exposition de l'ébauche (34, 38) à un rayonnement laser pulsé à une longueur d'onde de 193 nm.

5. Procédé selon l'une quelconque des revendications précédentes, selon lequel l'ébauche (32, 38) est chargée lors de la première étape à une température (T₁) de moins de 475 °C, de préférence de moins de 450 °C.

6. Procédé selon l'une quelconque des revendications précédentes, selon lequel l'ébauche (32, 38) est chargée lors de la deuxième étape à une température (T₂) de moins de 400 °C, de préférence de moins de 300 °C.

7. Procédé selon l'une quelconque des revendications précédentes, selon lequel l'ébauche (32, 38) est chargée lors de la première étape à une pression partielle d'hydrogène (p₁) de moins de 20 %, de préférence de moins de 10 %.

8. Procédé selon l'une quelconque des revendications précédentes, selon lequel l'ébauche (32, 38) est chargée lors de la deuxième étape à une pression partielle d'hydrogène (p₂) de 50 % ou plus, de préférence de 90 % ou plus, de manière particulièrement préférée de 100 % ou plus.

9. Élément lentille (33) en verre de quartz, sur lequel une surface (35) et une surface supplémentaire (36) pour le passage d'un rayonnement sont formées, l'élément lentille (33) présentant jusqu'à une distance (d₁) de 1 mm de la surface (35) une teneur en hydrogène ([H₂]) d'au moins 5 × 10¹⁶ molécules/cm³, de préférence d'au moins ⁵ × 10¹⁷ molécules/cm³, notamment d'au moins 10 x 10¹⁷ molécules/cm³, la teneur en hydrogène ([H₂]) chutant dans le volume de l'élément lentille (33) à une valeur minimale de 10 % ou moins de la teneur en hydrogène [(H₂)] à la surface (35), la teneur en hydrogène [(H₂)] chutant jusqu'à une distance (d₂) de 8 mm de la surface (35) à 50 % ou moins de la teneur en hydrogène [(H₂)] à la surface (35), et la teneur en silane se situant à tous les emplacements dans le volume de l'élément lentille (33, 37) à moins de 5 x 10¹⁴ molécules/cm³.

10. Élément lentille selon la revendication 9, dans lequel la teneur en silane ne varie pas de plus de 50 %, de préférence pas de plus de 30 %, notamment pas de plus de 20 %, sur l'épaisseur (D) de l'élément lentille (33) .

11. Élément lentille selon la revendication 9 ou 10, dans lequel la teneur en hydrogène [(H₂)] chute jusqu'à la distance (d₂) de 8 mm de la surface (35) à 40 % ou moins de la teneur en hydrogène [(H₂)] à la surface (35) .

12. Élément lentille selon l'une quelconque des revendications 9 à 11, dans lequel la teneur en hydrogène [(H₂)] chute jusqu'à une distance (d₃) de 25 mm de la surface (35) à 10 % ou moins de la teneur en hydrogène [(H₂)] à la surface (35).

13. Élément lentille selon l'une quelconque des revendications 9 à 12, dans lequel la teneur en hydrogène [(H₂)] n'augmente pas de plus de 30 % de la teneur en hydrogène [(H₂)] à la surface (35) depuis la valeur minimale dans la direction de l'épaisseur (z) de l'élément lentille (33) jusqu'à la surface supplémentaire (36) pour le passage d'un rayonnement.

14. Élément lentille selon l'une quelconque des revendications 9 à 13, qui présente lors d'une exposition à un rayonnement laser pulsé à une longueur d'onde de 193 nm une modification dK/dF du coefficient d'absorption K en fonction de la densité énergétique F de moins de 5 x 10⁻⁴ cm x puls/mJ, de préférence de moins de 1 x 10⁻⁴ cm x puls/mJ, de manière particulièrement préférée de moins de 5 x 10⁻⁵ cm/puls x mJ, notamment de moins de 1 x 10⁻⁵ cm x puls/mJ.

15. Élément lentille selon l'une quelconque des revendications 9 à 14, qui présente une teneur en OH de moins de 200 ppm en poids, de préférence de moins de 100 ppm en poids, de manière particulièrement préférée de moins de 20 ppm en poids, de manière tout particulièrement préférée de moins de 10 ppm en poids, notamment de moins de 10 ppm en poids.

16. Élément lentille selon l'une quelconque des revendications 9 à 15, qui présente pour un rayonnement à une longueur d'onde (λ_{B}) de 193,368 nm un indice de réfraction (n) de moins de 1,560830, de préférence de moins de 1,560810, de manière particulièrement préférée de moins de 1,560800, notamment de moins de 1,560790.

17. Élément lentille selon l'une quelconque des revendications 9 à 16, dans lequel la teneur en silane se situe à tous les emplacements dans le volume de l'élément lentille (33, 37) à moins de 1 x 10¹⁴ molécules/cm³, notamment à moins de 5 x 10¹³ molécules/cm³.

18. Élément lentille selon l'une quelconque des revendications 9 à 17, dont la déformation du front d'onde en raison du compactage lors de l'exposition à un rayonnement laser pulsé à une longueur d'onde de 193 nm n'augmente pas plus que linéairement avec la cadence des pulsations.

19. Élément lentille selon l'une quelconque des revendications 9 à 18, qui ne présente pas de formation de microcanaux après une dose de 200 milliards de pulsations avec une durée de pulsation à chaque fois de 150 ns à une densité énergétique de 0,5 mJ/cm²/puls ou à une dose de 3,5 milliards de pulsations avec une durée de pulsation à chaque fois de 130 ns à une densité énergétique de 6,5 mJ/cm²/puls.

20. Objectif de projection (11), notamment pour la lithographie par immersion, comprenant au moins un élément lentille (33, 37) selon l'une quelconque des revendications 9 à 19.

21. Objectif de projection selon la revendication 20, dans lequel l'élément lentille est un dernier élément lentille (33) de l'objectif de projection (11).
